# EUROPÄISCHE PATENTSCHRIFT

(11) **EP 2 947 696 B1**
(45) Veröffentlichungstag und Bekanntmachung des Hinweises auf die Patenterteilung: **02.09.2020**
(21) Anmeldenummer: 15168656.5
(22) Anmeldetag: 21.05.2015
(51) Int. Cl.: H01L 29/861, H01L 29/45, H01L 29/417, H01M 2/34

(54) **VORRICHTUNG UND VERFAHREN ZUR ÜBERBRÜCKUNG EINES ELEKTRISCHEN ENERGIESPEICHERS**
DEVICE AND METHOD FOR BRIDGING AN ELECTRICAL ENERGY STORE
DISPOSITIF ET PROCÉDÉ DE PONTAGE D'UN SYSTÈME DE STOCKAGE ÉLECTRIQUE

(30) Priorität: 23.05.2014 DE 102014107287
(43) Veröffentlichungstag der Anmeldung: 25.11.2015
(73) Patentinhaber: Fraunhofer-Gesellschaft zur Förderung der angewandten Forschung e.V., 80686 München (DE)
(72) Erfinder: Dr. Erlbacher, Tobias, 91099 Poxdorf (DE); Dr. Lorentz, Vincent, 91056 Erlangen (DE); Waller, Reinhold, 91077 Neunkirchen am Brand (DE); Rattmann, Gudrun, 91336 Heroldsbach (DE)
(74) Vertreter: 2SPL Patentanwälte PartG mbB

(56) Entgegenhaltungen:
- EP-A2- 0 226 360
- DE-A1- 3 426 199
- DE-C1- 19 723 747
- US-A1- 2006 065 891
- US-A1- 2010 244 194
- ROIG J ET AL: "Improved current filament control during Zener diode zapping", MICROELECTRONICS AND RELIABILITY, Bd. 52, Nr. 9, 1. September 2012 (2012-09-01), Seiten 2368-2373, XP028942125, ISSN: 0026-2714, DOI: 10.1016/J.MICROREL.2012.06.144
- M. M. Farahani ET AL: "Evaluation of Titanium as a Diffusion Barrier Between Aluminum and Silicon for 1.2 [mu]m CMOS Integrated Circuits", Journal of The Electrochemical Society, vol. 134, no. 11, 1 January 1987 (1987-01-01), page 2835, XP055634679, ISSN: 0013-4651, DOI: 10.1149/1.2100298
- Wen-Fa Wu ET AL: "Novel multilayered Ti/TiN diffusion barrier for Al metallization", Journal of Electronic Materials, 1 August 2005 (2005-08-01), pages 1150-1156, XP055571939, New York DOI: 10.1007/s11664-005-0244-9 Retrieved from the Internet: URL:https://link.springer.com/content/pdf/ 10.1007/s11664-005-0244-9.pdf

## Beschreibung

Ausführungsbeispiele der Erfindung beziehen sich auf ein Überbrückungselement und auf ein Verfahren zur Überbrückung einer Batteriezelle oder Akkumulatorzelle.

Energiespeicher (z.B. wiederaufladbare Batterien) finden sich in einer Vielzahl von Geräten, beispielsweise in mobilen Systemen, elektrischen Fahrzeugen, etc. Mobile Systeme verwenden beispielsweise seriell verbundene elektrische Energiespeicherzellen. Die Signifikanz und die Anzahl von mobilen Systemen, beispielsweise von sogenannten Smartphones, Tablet-Computern, Notebooks, hybriden/elektrischen Fahrzeugen, die auf dem Markt verfügbar werden, nimmt Jahr für Jahr zu. Nachdem die Elektronik in solchen mobilen Systemen eine immer wichtigere Rolle spielt, besteht ein permanent ansteigender Bedarf nach elektrischen Speichereinrichtungen. Während der letzten Jahre wurde beispielsweise die Automobilindustrie in Anbetracht von ökonomischen und ökologischen Anforderungen in Richtung der Einführung von hybriden Kraftfahrzeugen gedrängt, die zwei Energiequellen kombinieren, wobei einer der Energiequellen elektrische Energie bereitstellt. Die elektrische Energie wird im Allgemeinen in chemischer Form gespeichert, beispielsweise durch Batteriezellen, Akkumulatorzellen oder Kondensatorzellen. Um die in Kraftfahrzeugen mit elektrischen Antrieben erforderlichen hohen Spannungen und hohen Leistungen zu erreichen, werden mehrere dieser Zellen, beispielsweise zwischen vier bis mehr als 100 Zellen, in Serie verbunden, wodurch ein Stapel von Zellen erzeugt wird. Eine Hauptherausforderung der in Serie bzw. in Parallel verschalteten Zellen ist die Zuverlässigkeit des gesamten Stapels und die Umorganisation des Stapels im Fall eines Zellenfehlers. Derzeit ist es so, dass bei Ausfall einer Zelle in dem Stapel, das gesamte System nicht mehr in der Lage ist, zu arbeiten, obwohl der Stapel als solcher immer noch eine ausreichende Anzahl von intakten Zellen umfasst, um einen Betrieb des Systems zu ermöglichen. Ist das System ein reines Elektrofahrzeug, aber auch im Fall der meisten hybriden Fahrzeuge, führt ein solcher Zellenfehler im Regelfall zu einem kompletten Systemausfall.

Für den zuverlässigen Betrieb von Elektrofahrzeugen werden Batteriemanagementsysteme eingesetzt. Neben der Überwachung von Ladezustand und "Gesundheit" der Batteriezellen kann es Aufgabe des Batteriemanagementsystems sein, eine Symmetrierung der Batteriezellen herzuführen. Im Falle einer einzelnen defekten (entladenen) Zelle kann der gesamte Batteriestrang ausfallen. Daher ist es erwünscht, derartige Zellen durch ein parallel geschaltetes Überbrückungselement kurzzuschließen und somit zu überbrücken. Dabei sollte die Überbrückung einer gesunden/geladenen Zelle vermieden werden, da in diesem Zustand die kurzgeschlossene Zelle eine große Erwärmung durch die Selbstentladung auslösen kann.

Überbrückungselemente zur Überbrückung einer Batteriezelle oder Akkumulatorzelle sind aus der EP 0 226 360 A2 und der DE 3426199 A1 bekannt. Beim Auftreten vordefinierter Auslösekonditionen, insbesondere wenn die Batteriezelle oder Akkumulatorzelle, zu der sie parallel geschaltet sind, hochohmig wird, werden die darin offenbarten Überbrückungselemente dauerhaft kurzgeschlossen. Dabei überbrücken sie die Batteriezelle oder Akkumulatorzelle. Die Überbrückung erfolgt, indem die Anschlussstrukturen und die Halbleiterdioden der Überbrückungselemente wegen der Temperaturerhöhung schmelzen, die durch den Strom verursacht wird, der nach dem Hochohmigwerden der parallel geschalteten Zelle durch die Überbrückungselemente fließt.

Es besteht der Bedarf ein verbessertes Konzept zur Überbrückung eines elektrischen Energiespeichers zu schaffen, dass es ermöglicht die Zuverlässigkeit und/oder Betriebssicherheit von Energieversorgungssystemen zu erhöhen und/oder die Kosten zu senken.

Der Bedarf kann durch die Gegenstände der Ansprüche gedeckt werden.

Das erfindungsgemäße Überbrückungselement umfasst ein Halbleitersubstrat mit einem an einer Oberfläche des Halbleitersubstrats angeordneten ersten Dotierungsgebiet und einem an das erste Dotierungsgebiet angrenzendes zweites Dotierungsgebiet. Das erste Dotierungsgebiet weist einen ersten Leitfähigkeitstyp und das zweite Dotierungsgebiet weist einen zweiten Leitfähigkeitstyp auf. Der pn-Übergang zwischen dem ersten Dotierungsgebiet und dem zweiten Dotierungsgebiet ist zumindest teilweise weniger als 5 µm von einem an der Oberfläche des Halbleitersubstrats angeordneten Anschlussbereich des ersten Dotierungsgebiets entfernt angeordnet. Ferner umfasst die Vorrichtung eine erste Anschlussstruktur, die in dem Anschlussbereich des ersten Dotierungsgebiets mit dem ersten Dotierungsgebiet in Kontakt ist und zumindest teilweise ein zur Diffusion in das Halbleitersubstrat vorgesehenes, elektrisch leitfähiges Material aufweist. Die erste Anschlussstruktur ist ausgelegt, sodass das zur Diffusion in das Halbleitersubstrat vorgesehene, elektrisch leitfähige Material bei Auftreten von vordefinierten Auslösekonditionen zumindest teilweise durch das erste Dotierungsgebiet bis in das zweite Dotierungsgebiet diffundiert. Zusätzlich weist die Vorrichtung eine zweite Anschlussstruktur auf, die in einem Anschlussbereich des zweiten Dotierungsgebiets mit dem zweiten Dotierungsgebiet in Kontakt ist.

Durch die Verwendung des zur Diffusion in das Halbleitersubstrat vorgesehenen, elektrisch leitfähigen Materials in der Anschlussstruktur eines dünnen Dotierungsgebiets einer Diode kann das dünne Dotierungsgebiets bei Auftreten der vordefinierten Auslösebedingungen zumindest teilweise durchlegiert werden und so ein niederohmiger Strompfad erzeugt werden. Dadurch kann ein Überbrückungselement mit hoher Zuverlässigkeit und/oder geringen Kosten realisiert werden.

Durch das Eindiffundieren des zur Diffusion in das Halbleitersubstrat vorgesehenen, elektrisch leitfähigen Materials bei Auftreten der vordefinierten Auslösekonditionen bis in das zweite Dotierungsgebiet wird der pn-Übergang zumindest teilweise zerstört. Dadurch verringert sich der Widerstand zwischen den beiden Anschlussstrukturen insbesondere in Sperrrichtung des pn-Übergangs deutlich. Z.B. ist der elektrische Wiederstand zwischen der ersten und zweiten Anschlussstruktur vor einem Auftreten der vordefinierten Auslösebedingungen mehr als 1000 mal (oder mehr als 10000 mal, mehr als 100000 mal oder mehr als 1000000 mal) größer als nach einem Auftreten der vordefinierten Auslösebedingungen.

Einige Ausführungsbeispiele beziehen sich auf eine Vorrichtung, die eine auf einem Halbleiterchip integrierten Halbleiterdiode und ein erstes elektrisch leitfähiges Anschlusselement, das mit einer ersten Anschlussstruktur der Halbleiterdiode auf einer Vorderseite des Halbleiterchips verbunden ist, aufweist. Ferner weist die Vorrichtung ein zweites elektrisch leitfähiges Anschlusselement auf, das mit einer zweiten Anschlussstruktur der Halbleiterdiode auf einer Rückseite des Halbleiterchips verbunden ist. Dabei erstreckt sich ein Kontaktbereich zwischen dem zweiten elektrisch leitfähigen Anschlusselement und der Rückseite des Halbleiterchips über weniger als 70% der Fläche der Rückseite des Halbleiterchips.

Durch die Reduktion der Kontaktfläche zwischen dem Rückseitenanschluss des Überbrückungselements kann die Wärmeabfuhr über den Rückseitenanschluss deutlich reduziert werden. Dadurch kann mit geringerem Strom über die Halbleiterdiode eine schnellere oder größere Erwärmung erreicht werden. Beispielsweise kann auf diesem Weg vereinfacht die Halbleiterdiode zumindest teilweise durchlegieren und ein niederohmiger Strompfad er zeugt werden. So kann das Auslösen des Überbrückungselements einfacher, schneller und/oder zuverlässiger erfolgen.

Weitere Ausführungsbeispiele beziehen sich auf ein Verfahren zur Überbrückung einer Batteriezelle oder Akkumulatorzelle. Das Verfahren umfasst ein Sperren eines Stromflusses durch ein Überbrückungselement, das ein Halbleitersubstrat mit einem an einer Oberfläche des Halbleitersubstrats angeordneten ersten Dotierungsgebiet und einem an das erste Dotierungsgebiet angrenzendes zweites Dotierungsgebiet aufweist. Das erste Dotierungsgebiet weist einen ersten Leitfähigkeitstyp und das zweite Dotierungsgebiet weist einen zweiten Leitfähigkeitstyp auf. Der pn-Übergang zwischen dem ersten Dotierungsgebiet und dem zweiten Dotierungsgebiet ist zumindest teilweise weniger als 5µm von einem an der Oberfläche des Halbleitersubstrats angeordneten Anschlussbereich des ersten Dotierungsgebiets entfernt angeordnet. Das Überbrückungselement weist eine zumindest teilweise zur Diffusion in das Halbleitersubstrat vorgesehenes, elektrisch leitfähiges Material aufweisende erste Anschlussstruktur auf, die in dem Anschlussbereich des ersten Dotierungsgebiets mit dem ersten Dotierungsgebiet in Kontakt ist. Ferner umfasst das Verfahren ein Überführen des Überbrückungselements in einen leitenden Zustand bei Auftreten von vordefinierten Auslösekonditionen durch zumindest teilweises Diffundieren des zur Diffusion in das Halbleitersubstrat vorgesehenen, elektrisch leitfähigen Materials durch das erste Dotierungsgebiet bis in das zweite Dotierungsgebiet.

Ausführungsbeispiele der Erfindung werden nachfolgend unter Bezugnahme auf die beiliegenden Zeichnungen näher erläutert. Es zeigen:
- Fig. 1: einen schematischen Querschnitt einer Vorrichtung zur Überbrückung eines elektrischen Energiespeichers;
- Fig. 2: ein Strom-Spannungs-Diagramm einer Vorrichtung zur Überbrückung eines elektrischen Energiespeichers vor und nach Auftreten von vordefinierten Auslösekonditionen;
- Fig. 3a: eine schematische Draufsicht auf eine Vorrichtung zur Überbrückung eines elektrischen Energiespeichers;
- Fig. 3b: eine schematische Seitenansicht einer Vorrichtung zur Überbrückung eines elektrischen Energiespeichers;
- Fig. 4: eine schematische dreidimensionale Ansicht einer Vorrichtung zur Überbrückung eines elektrischen Energiespeichers;
- Fig. 5: eine Ansicht eines Gehäuses einer Vorrichtung zur Überbrückung eines elektrischen Energiespeichers;
- Fig. 6: eine schematische dreidimensionale Ansicht einer Vorrichtung zur Überbrückung eines elektrischen Energiespeichers mit simulierter Temperaturverteilung;
- Fig. 7: ein Energiespeicherpaket, welches mit einem elektrischen Antrieb, wie er beispielsweise in einem Elektrofahrzeug zum Einsatz kommt, gekoppelt ist;
- Fig. 8: ein Energiespeicherpaket ähnlich dem, welches anhand der Fig. 7 beschrieben wurde;
- Fig. 9: in Reihe geschaltete Energiequellen mit überbrückenden Leistungselementen, wobei Fig. 9(a) eine Reihe von Energiequellen zeigt, die alle im Normalbetrieb arbeiten, und Fig. 9(b) eine Situation zeigt, bei der eine der Energiequellen fehlerhaft ist;
- Fig. 10: ein System, welches inverse Sicherungen umfasst; und
- Fig. 11: eine schematische Darstellung einer inversen Sicherung, wobei Fig. 11(a) die in den Fig. 3 und 4 verwendeten Symbole für die inverse Sicherung zeigt, und wobei Fig. 11(b) eine schematische Darstellung des Aufbaus einer inversen Sicherung zeigt; und
- Fig. 12: ein Flussdiagramm eines Verfahrens zur Überbrückung eines elektrischen Energiespeichers.

Verschiedene beispielhafte Ausführungsformen werden nun ausführlicher unter Bezugnahme auf die beigefügten Zeichnungen beschrieben, in denen einige beispielhafte Ausführungsformen dargestellt werden. In den Figuren können die Stärken von Linien, Schichten und/oder Bereichen zur Verdeutlichung übertrieben sein.

Während sich beispielhafte Ausführungsformen für verschiedene Modifikationen und alternative Ausbildungen eignen, werden dementsprechend die Ausführungsformen davon in den Figuren beispielhaft gezeigt und werden hier ausführlich beschrieben. Es sollte allerdings zu verstehen sein, dass keine Absicht besteht, beispielhafte Ausführungsformen auf die besonderen offenbarten Ausbildungen zu beschränken, sondern dass beispielhafte Ausführungsformen im Gegenteil vorgesehen sind, um alle Modifikationen, Entsprechungen und Alternativen abzudecken, die in den Schutzumfang der Offenbarung fallen. Überall in der Beschreibung der Figuren betreffen gleiche Bezugszeichen gleiche oder ähnliche Elemente.

Es ist zu verstehen, dass, wenn sich auf ein Element als mit einem anderen Element "verbunden" oder "gekoppelt" bezogen wird, es direkt mit dem anderen Element verbunden oder gekoppelt werden kann oder, dass Zwischenelemente vorhanden sein können. Im Gegensatz dazu, wenn sich auf ein Element als mit einem anderen Element "direkt verbunden" oder "direkt gekoppelt" bezogen wird, sind keine Zwischenelemente vorhanden. Andere Ausdrücke, um die Beziehung zwischen Elementen zu beschrieben, sollten in gleicher Weise (z. B. "zwischen" versus "direkt zwischen", "neben" versus "direkt neben" usw.) interpretiert werden.

Die hier verwendete Terminologie ist nur für den Zweck vorgesehen, besondere Ausführungsformen zu beschreiben, und es ist nicht beabsichtigt, beispielhafte Ausführungsformen einzuschränken. Wie hier verwendet, sind die Singularformen "ein", "eine", "einer" und "der, die, das" vorgesehen, auch die Pluralformen mit einzuschließen, es sei denn im Zusammenhang wird deutlich etwas anderes angegeben. Es ist des Weiteren zu verstehen, dass, wenn die Ausdrücke "umfassen", "umfassend", "aufweisen" und/oder "aufweisend" hier verwendet werden, sie das Vorhandensein von erklärten Eigenschaften, ganzen Zahlen, Schritten, Vorgängen, Elementen und/oder Komponenten spezifizieren, aber nicht das Vorhandensein oder das Hinzufügen von einer oder mehreren Eigenschaften, ganzen Zahlen, Schritten, Vorgängen, Elementen, Komponenten und/oder Gruppen davon ausschließen.

Es sei denn, es ist anders definiert, haben alle hier verwendeten Ausdrücke (einschließlich technischer und wissenschaftlicher Ausdrücke) dieselbe Bedeutung, wie sie herkömmlicherweise von einem normalen Fachmann auf dem Gebiet verstanden wird, zu dem diese beispielhaften Ausführungsformen gehören. Es ist des Weiteren zu verstehen, dass Ausdrücke, z. B. diejenigen, die in herkömmlich verwendeten Wörterbüchern definiert sind, so interpretiert werden sollen, dass sie eine Bedeutung haben, die mit ihrer Bedeutung im Zusammenhang mit der betreffenden Technik übereinstimmt, und sie werden nicht idealisierend oder in einem übermäßig formalen Sinn interpretiert, es sei denn, es ist hier ausdrücklich so definiert.

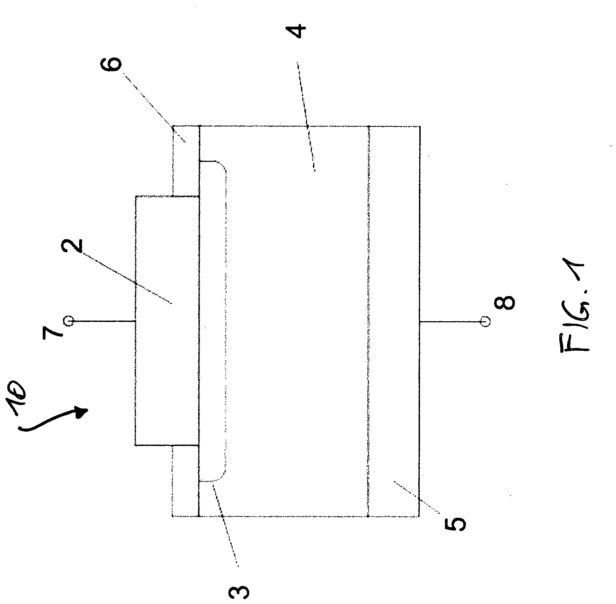

Fig. 1 zeigt eine Vorrichtung 10 zur Überbrückung eines elektrischen Energiespeichers 2. in Form von einer Batteriezelle oder Akkumulatorzelle gemäß einem Ausführungsbeispiel. Die Vorrichtung 10 umfasst ein Halbleitersubstrat mit einem an einer Oberfläche des Halbleitersubstrats angeordneten ersten Dotierungsgebiet 3 und einem an das erste Dotierungsgebiet 3 angrenzendes zweites Dotierungsgebiet 4. Das erste Dotierungsgebiet 3 weist einen ersten Leitfähigkeitstyp und das zweite Dotierungsgebiet 4 weist einen zweiten Leitfähigkeitstyp auf. Der pn-Übergang zwischen dem ersten Dotierungsgebiet 3 und dem zweiten Dotierungsgebiet 4 ist zumindest teilweise weniger als 5µm von einem an der Oberfläche des Halbleitersubstrats angeordneten Anschlussbereich des ersten Dotierungsgebiets 3 entfernt angeordnet. Ferner umfasst die Vorrichtung eine erste Anschlussstruktur 2, die in dem Anschlussbereich des ersten Dotierungsgebiets 3 mit dem ersten Dotierungsgebiet 3 in Kontakt ist und zumindest teilweise ein zur Diffusion in das Halbleitersubstrat vorgesehenes, elektrisch leitfähiges Material aufweist. Die erste Anschlussstruktur 2 ist ausgelegt, sodass das zur Diffusion in das Halbleitersubstrat vorgesehene, elektrisch leitfähige Material bei Auftreten von vordefinierten Auslösekonditionen zumindest teilweise durch das erste Dotierungsgebiet 3 bis in das zweite Dotierungsgebiet 4 diffundiert. Zusätzlich weist die Vorrichtung eine zweite Anschlussstruktur 5, die in einem Anschlussbereich des zweiten Dotierungsgebiets 4 mit dem zweiten Dotierungsgebiet 4 in Kontakt ist.

Durch die Verwendung des zur Diffusion in das Halbleitersubstrat vorgesehenen, elektrisch leitfähigen Materials in der Anschlussstruktur eines dünnen Dotierungsgebiets einer Diode kann das dünne Dotierungsgebiets bei Auftreten der vordefinierten Auslösebedingungen zumindest teilweise durchlegiert werden und so ein niederohmiger Strompfad erzeugt werden. Dadurch kann ein Überbrückungselement mit hoher Zuverlässigkeit und/oder geringen Kosten realisiert werden.

Das Halbleitersubstrat kann beispielsweise ein Siliziumsubstrat, ein Siliziumcarbidsubstrat oder eine Galliumarsenidsubstrat sein.

Die Oberfläche oder Hauptoberfläche des Halbleitersubstrat ist beispielsweise die Schnittstelle zwischen dem Halbleitermaterial des Halbleitersubstrats zu daran anschließenden Isolatorstrukturen, Isolatorschichten, Metallstrukturen, Metallschichten oder Passivierungschichten. Das Halbleitersubstrat weist eine Vorderseite und eine im Wesentlichen dazu parallele Rückseite auf. Die Vorderseite ist dabei z.B. jene Seite an der komplexere Strukturen implementiert sind oder komplexere Prozesse ausgeführt werden als auf der Rückseite. Die Vorderseite und Rückseite sind im Wesentlichen ebene Oberflächen (z.B. unter Vernachlässigung von Fertigungstoleranzen oder Grabenstrukturen).

Das erste Dotierungsgebiet 3 kann sich entlang eines Teils der Oberfläche oder der gesamten Oberfläche des Halbleitersubstrats (z.B. an der Vorderseite) erstrecken. Dabei kann sich das erste Dotierungsgebiet 3 z.B. bis in eine maximale Tiefe von 5 µm (oder maximal 2 µm, maximal 1 µm, maximal 500nm, maximal 250nm oder maximal 100m) erstrecken.

Das zweite Dotierungsgebiet 4 grenzt an das erste Dotierungsgebiet 3 an. Aufgrund der unterschiedlichen Leitfähigkeitstypen der Dotierungsgebiete bildet sich zwischen den Dotierungsgebieten ein pn-Übergang aus. Die Tiefe des pn-Übergangs richtet sich damit beispielsweise nach der Tiefe des ersten Dotierungsgebiets 3. Der pn-Übergang ist also beispielsweise weniger als 5 µm (oder weniger als 2 µm, weniger als 1 µm, weniger als 500nm, weniger als 250nm oder weniger als 100nm, z.B. 350 nm) von dem an der Oberfläche des Halbleitersubstrats angeordneten Anschlussbereich des ersten Dotierungsgebiets 3 entfernt angeordnet.

Das zweite Dotierungsgebiet 4 nimmt zumindest einen Teil des nicht von dem ersten Dotierungsgebiet 3 eingenommenen Teil des Halbleitersubstrats ein oder kann sich über den gesamten nicht von dem ersten Dotierungsgebiet 3 eingenommenen Teil des Halbleitersubstrats erstrecken.

Das zweite Dotierungsgebiet 4 kann beispielsweise eine Grunddotierungskonzentration des Halbleitersubstrats aufweisen oder eine durch Diffusion oder Implantation erhöhte Dotierstoffkonzentration. Z.B. kann eine durchschnittliche Dotierstoffkonzentration (z.B. gemittelt über das zweite Dotierungsgebiet) in dem zweiten Dotierungsgebiet 4 höher als 1^{∗}10¹⁸cm⁻³ (oder höher als 4^{∗}10¹⁸cm⁻³ oder höher als 1^{∗}10¹⁹cm⁻³) sein.

Das erste Dotierungsgebiet 3 kann beispielsweise durch Diffusion oder Implantation von Dotierstoffen, die im Halbleitersubstrat den ersten Leitfähigkeitstyp bilden, erzeugt werden. Z.B. kann eine durchschnittliche Dotierstoffkonzentration (z.B. gemittelt über das erste Dotierungsgebiet) in dem ersten Dotierungsgebiet 3 höher als 4^{∗}10¹⁸cm⁻³ (oder höher als 1^{∗}10¹⁹cm⁻³ oder höher als 4^{∗}10¹⁹cm⁻³) sein.

Die Sperrspannung der Diode kann beispielweise durch die Dotierungskonzentration in den Dotierungsgebieten eingestellt werden.

Der Leitfähigkeitstyp eines Dotierungsgebiets kann durch eine n-Dotierung (z.B. durch Einbringen von Stickstoffionen, Phosphorionen oder Arsenionen) oder eine p-Dotierung (z.B. durch Einbringen von Aluminiumionen oder Borionen) resultieren. Beispielsweise ist der erste Leitfähigkeitstyp verursacht durch eine n-Dotierung und der zweite Leitfähigkeitstyp verursacht durch eine p-Dotierung oder umgekehrt. Entsprechend ist das erste Dotierungsgebiet 3 beispielsweise ein n-dotiertes Gebiet und das zweite Dotierungsgebiet 4 ein p-dotiertes Gebiet oder umgekehrt.

Durch das Eindiffundieren des zur Diffusion in das Halbleitersubstrat vorgesehenen, elektrisch leitfähigen Materials bei Auftreten der vordefinierten Auslösekonditionen bis in das zweite Dotierungsgebiet 4 wird der pn-Übergang zumindest teilweise zerstört. Dadurch verringert sich der Widerstand zwischen den beiden Anschlussstrukturen insbesondere in Sperrrichtung des pn-Übergangs deutlich. Z.B. ist der elektrische Wiederstand zwischen der ersten und zweiten Anschlussstruktur vor einem Auftreten der vordefinierten Auslösebedingungen mehr als 1000 mal (oder mehr als 10000 mal, mehr als 100000 mal oder mehr als 1000000 mal) größer als nach einem Auftreten der vordefinierten Auslösebedingungen. Beispielsweise weist die Vorrichtung 10 zwischen der ersten und zweiten Anschlussstruktur nach einem Auftreten der vordefinierten Auslösebedingungen einen Widerstand von weniger als 100 mOhm/cm² (oder weniger als 10 mOhm/cm²) auf.

Die erste Anschlussstruktur 2 kann beispielsweise eine Metallschicht oder Metallschichtstapel in direktem Kontakt mit dem ersten Dotierungsgebiet 3 sein (z.B. auch direkt von außen über Bonddrähte oder Lötverbindungen kontaktierbar) oder sich über eine oder mehrere weitere Metalllagen, die durch Zwischenmetalloxid isoliert sind, zu einem Pad (z.B. zur Kontaktierung über Bonddrähte oder Lötverbindungen) erstrecken.

Der Anschlussbereich der zweiten Anschlussstruktur 5 kann beispielsweise an einer Rückseite des Halbleitersubstrats angeordnet sein, die der den Anschlussbereich der ersten Anschlussstruktur aufweisenden Oberfläche des Halbleitersubstrats gegenüber liegt. Dadurch kann beispielsweise eine vertikale Diode implementiert werden. Alternativ kann auch eine laterale Diode implementiert werden und der Anschlussbereich der zweiten Anschlussstruktur 5 kann auf derselben Seite des Halbleitersubstrats, wie der Anschlussbereich der ersten Anschlussstruktur angeordnet sein.

Das zur Diffusion in das Halbleitersubstrat vorgesehene, elektrisch leitfähige Material ist beispielsweise Teil der Metallschicht, die in direktem Kontakt mit dem ersten Dotierungsgebiet 3 ist, oder bildet die Metallschicht, die in direktem Kontakt mit dem ersten Dotierungsgebiet 3 ist. Zwischen dem Halbleitersubstrat und dem zur Diffusion in das Halbleitersubstrat vorgesehene, elektrisch leitfähige Material kann eine Barriereschicht (z.B. Titan oder Titannitrid) angeordnete sein, damit eine Diffusion vor Auftreten der vordefinierten Auslösekonditionen unterdrückt werden kann. Alternativ kann das zur Diffusion in das Halbleitersubstrat vorgesehene, elektrisch leitfähige Material der ersten Anschlussstruktur vor Auftreten der Auslösebedingungen in dem Anschlussbereich der ersten Anschlussstruktur mit dem ersten Dotierungsgebiet 3 in direktem Kontakt sein. Dadurch kann beispielsweise eine Diffusion erleichtert werden.

Das zur Diffusion in das Halbleitersubstrat vorgesehene, elektrisch leitfähige Material der ersten Anschlussstruktur ist erfindungsgemäß ein in dem Halbleitersubstrat den zweiten Leitfähigkeitstyp ergebender Dotierstoff. In anderen Worten, das zur Diffusion in das Halbleitersubstrat vorgesehene, elektrisch leitfähige Material der ersten Anschlussstruktur kann beispielsweise ein Material sein, das auch für eine Dotierung des zweiten Leitfähigkeitstyps verwendet werden kann. Dadurch kann bei Diffusion in das erste Dotierungsgebiet 3 dieses zumindest teilweise in ein Gebiet des zweiten Leitfähigkeitstyps umgewandelt werden oder Nadeln dieses Material (spiking) bis in das zweite Dotierungsgebiet 4 wachsen und so das erste Dotierungsgebiet 3 zumindest teilweise durchlegieren. Das zur Diffusion in das Halbleitersubstrat vorgesehene, elektrisch leitfähige Material der ersten Anschlussstruktur kann beispielsweise Aluminium, Bor, Gallium oder Indium oder eine Legierung einer dieser Materialien sein. Z.B. kann das zur Diffusion in das Halbleitersubstrat vorgesehene, elektrisch leitfähige Material Aluminium mit einem Reinheitsgrad von mehr als 95% (oder mehr als 99% oder mehr als 99,9%) sein. Beispielsweise kann das zur Diffusion in das Halbleitersubstrat vorgesehene, elektrisch leitfähige Material der ersten Anschlussstruktur Aluminium aufweisen und das zweite Dotierungsgebiet 4 Bor als Dotierstoff aufweisen. Dadurch kann sich nach Diffusion im zweiten Dotierungsgebiet 4 zumindest teilweise ein Dotierung mit zwei unterschiedlichen Dotierstoffen des gleichen Leitfähigkeitstyps ergeben.

Alternativ kann das zur Diffusion in das Halbleitersubstrat vorgesehene, elektrisch leitfähige Material der ersten Anschlussstruktur ein in dem Halbleitersubstrat keinen Dotierstoff bildendes Material sein. Z.B. können dazu Elemente der vierten Hauptgruppe (z.B. Si) oder Metalle (z.B. Nickel oder Titan) verwendet werden, die mit Silizium ein Silizid bilden.

Die vordefinierten Auslösekonditionen können durch mehrere Parameter festgelegt sein. Beispielweise können die Auslösekonditionen durch einen vordefinierten Auslösestrom, eine vordefinierte Auslösezeit und/oder eine vordefinierte Auslösetemperatur festgelegt werden. Die vordefinierten Auslösekonditionen legen beispielsweise Bedingungen fest bei denen die Diffusion des zur Diffusion in das Halbleitersubstrat vorgesehenen, elektrisch leitfähigen Materials der ersten Anschlussstruktur bis in das zweite Dotierungsgebiet 4 für die jeweilige Anwendung ausreichend schnell und in ausreichender Menge erfolgt, um einen ausreichend niederohmigen Strompfad zu erzeugen.

Die Auslösetemperatur kann beispielsweise eine durch den Auslösestrom und die Auslösezeit ausgehend von der Betriebstemperatur oder von Raumtemperatur erreichbare Temperatur sein.

In anderen Worten, die vordefinierten Auslösekonditionen können beispielsweise durch einen vordefinierten Auslösestrom zwischen der ersten Anschlussstruktur und der zweiten Anschlussstruktur 5 für eine vordefinierte Auslösezeit erreicht werden. Beispielsweise kann der Auslösestrom zwischen 0,1 A/mm² und 10 A/mm² (z.B. 0,5 A/mm² , 1A/mm² oder 5 A/mm²) liegen. Die Auslösezeit kann beispielsweise zwischen 0,1s und 10s (oder zwischen 0,5s und 5s) liegen.

Die auf dem Halbleitersubstrat gebildete Diode kann beispielsweise eine Durchbruchspannung aufweisen, die dem 1,2 bis 2-fachen einer Spannung des zu überbrückenden Energiespeichers entspricht. Z.B. kann die Durchbruchspannung der Diode zwischen 4V und 10V (oder zwischen 5V und 6V) liegen.

Der Auslösestrom kann beispielsweise von Batterieelementen, die mit einem durch das Überbrückungselement zu überbrückenden Batterieelement in Serie gekoppelt sind, bereitgestellt werden oder von einem Überwachungsmodul (z.B. Teil eines Energiemanagementsystems) bereitgestellt werden.

Die Vorrichtung 10 kann beispielsweise auch Überbrückungselement oder inverse Sicherung genannt werden oder auch neben einem durch die Halbleiterdiode realisiertes Überbrückungselement oder inverse Sicherung noch weitere Komponenten (z.B. Anschlusselemente, Gehäuse, Überwachungsmodul, Mehrzahl von Überbrückungselementen) aufweisen.

Die Vorrichtung 10 kann eine Batteriezelle oder Akkumulatorzelle überbrücken, wenn diese z.B. defekt ist.

Die Dotierung und Metallisierung der Halbleiterdiode ist beispielsweise auf den Einsatz als inverse Sicherung in einer Batterie (elektrischer Energiespeicher) - z.B. eine Traktionsbatterie, z.B. Lithium-Ionen-Akkumulatoren für einen Elektromotor mit einer Ausgangsspannung von ca. 400V und eine maximale Stromstärke von ca. 100A- ausgelegt. Der Leckstrom vor dem Auslösen liegt beispielsweise unter 100µA/cm². Nach dem Auslösen kann ein Serienwiderstand von weniger als 10 mOhm bzw. 10 mOhm/cm² erreicht werden. Ein möglicher Aufbau einer Ausführung der Diode ist in Fig. 1 dargestellt. Fig. 1 zeigt beispielsweise eine inverse Halbleitersicherung zur Überbrückung einer Akkumulatorzelle.

Die inverse Halbleitersicherung 10 umfasst beispielsweise ein Halbleitersubstrat mit einem hochdotierten ersten Halbleitergebiet (z.B. aus Silizium) 4 mit einem ersten Dotierungstyp, welches auch bei unvollständiger Durchlegierung der gesamten Halbleiterschicht einen niederohmigen Kurzschluss erlaubt - als erster Dotiertyp wird beispielsweise Bor verwendet.

Ferner umfasst die Halbleitersicherung 10 einen noch höher dotierten zweiten Halbleiterbereich (z.B. aus Silizium) 3 auf dem ersten Halbleitergebiet 4 mit einem zweiten Dotierungstyp, so dass sich ein sperrfähiger pn-Übergang bildet; der Bereich 3 ist beispielsweise so dünn dimensioniert (z.B. zwischen 100nm bis 5µm oder zwischen 250 und 500nm), dass auch bei einer Auslösung mit einer möglichst niedrigen Flussstromdichte eine Durchlegierung ermöglicht wird - der zweite Dotierstofftyp ist entsprechend beispielsweise Phosphor oder Arsen.

Zusätzlich umfasst die Halbleitersicherung 10 beispielsweise eine Metallisierungsschicht 2 aus einem Material, welches (z.B. bei Temperaturen über 400°C) eine Legierung mit dem zweiten Halbleiterbereich 3 bildet und als ersten elektrischen Anschluss 7 dient und beim Durchlegieren einen niederohmigen (ohmschen) Kontakt im ersten Halbleitergebiet bildet (wobei das erste Halbleitergebiet nicht vollständig durchlegiert werden muss).

In einer möglichen Ausführung für Anwendungen bei Raumtemperatur (< 150°C) wird beispielsweise Aluminium (mit einem Reinheitsgrad über 99.9%) als Kontaktmaterial zum zweiten Halbleiterbereich 3 verwendet. Alternativ kann auch AlSi1% - also 99% reines Alu mit Si-Anteil - verwendet werden.

Für höhere Betriebstemperaturen können auch andere Metalle verwendetet werden (grundsätzlich stehen für den skizzierten Aufbau auch andere in Silizium p-dotierende Materialien wie Bor, Gallium, Indium und Thallium als Elemente der 3. Gruppe des Periodensystems zur Verfügung). Es kann ein Metall gewählt werden, sodass der eutektische Punkt bei der Legierungsbildung deutlich oberhalb der Betriebstemperatur liegt, so dass die Sicherung nicht allein durch die Betriebstemperatur ausgelöst wird.

Zusätzlich kann eine Rückseitenmetallisierung 5 verwendet werden, welche den zweiten elektrischen Kontakt 8 darstellt und die beim Auslösen des Überbrückungselements ebenfalls einlegieren kann, aber nicht muss. Neben Aluminium sind beispielsweise auch lötbare Schichtstapel (z.B. aus Cr/Ni/Ag oder Kupfer) oder bondbare Schichtstapel aus einer Haftschicht (TiN/TaN/Cr) und Aluminium, AlSiCu oder AlSi möglich.

Zum Auslösen wird die Diode z.B. in Flussrichtung betrieben, so dass ein hinreichend großer Auslösestrom (Stromdichte) fließen kann, der zum Durchlegieren führt.

Ferner kann das Bauelement so dimensioniert werden, dass es bei einem zu hohen Sperrstrom der Diode ebenfalls auslösen kann, um die Batterie vor Überladung zu schützen. Dies kann z.B. eine einfache Schottkydiode nicht leisten. In anderen Worten, die vordefinierten Auslösekonditionen können sowohl durch einen Auslösestrom in Flussrichtung des pn-Übergangs als auch einen Auslösestrom in Sperrrichtung des pn-Übergangs erreichbar sein.

Optional kann auf der Vorderseite eine Isolations-/Passivierschicht 6 z.B. Siliziumdioxid oder Polyimid eingesetzt werden, um die Entwärmung beim Auslösen zu begrenzen und so ein effizientes Durchlegieren bei begrenzter thermischer Energie zu gewährleisten.

Nach dem Durchlegieren befinden sich in einer möglichen Ausführung zwei unterschiedliche Dotierstoffe des ersten Dotierstofftyps im ersten Halbleiterbereich nahe der Grenzfläche zum zweiten Halbleiterbereich (z.B. Bor und Aluminium). Das diffundieren Aluminium aus der Metallisierungsschicht 2 stellt insbesondere denselben Dotierstofftyp dar wie das im ersten Halbleitergebiet 4 vorhandene Bor. Dadurch bildet sich nach der Durchlegierung ein niederohmiger, ohmischer (z.B. im Gegensatz zu einem Schottkykontakt) Kontakt zwischen diesen beiden Bereichen.

In einer möglichen Ausführung umfasst das Halbleitersubstrat 4 hoch p-leitendes (z.B. mit Bor dotiert) Siliziumsubstrat mit einer Schichtdicke unter 500µm (z.B. unter 200µm). Die Dotierstoffkonzentration liegt beispielsweise bei etwa 10¹⁹ cm⁻³.

Der Halbleiterbereich 3 kann z.B. durch Ionenimplantation oder Diffusion von Phosphor oder Arsen als hoch n-leitende Schicht ausgelegt werden und höher dotiert werden als das Halbleitersubstrat 4, z.B. über 4^{∗}10¹⁹cm⁻³. Dabei ist der pn-Übergang beispielsweise zwischen 100nm und 500nm tief (entspricht der Ausdehnung des Halbleiterbereichs 3). Eine Strukturierung des Halbleiterbereichs 3 ist nicht zwingend notwendig. Das Vereinzeln der Halbleiterbauelemente durch Sägen durch den pn-Übergang ist zulässig, kann jedoch zu einem höheren Leckstrom im nicht ausgelösten Zustand führen. Die Isolation 6 ist ebenfalls nicht zwingend notwendig, durch geeignete Wahl deren Geometrie kann jedoch auf den Ort der Legierung und die Entwärmung während des Legierungsvorgangs Einfluss genommen werden.

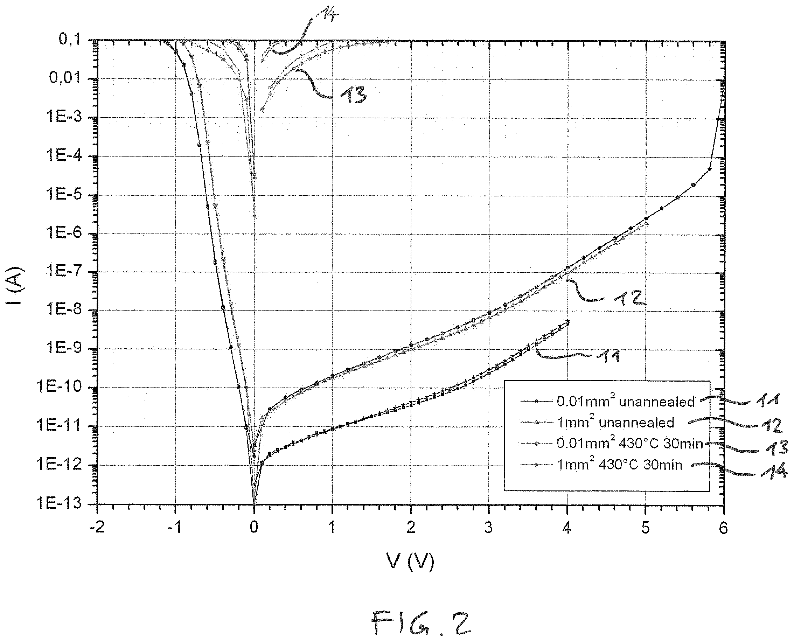

In Fig. 2 sind Strom-Spannungskennlinien eines solchen Sicherungselements vor und nach dem Auslösen dargestellt.

Im Detail zeigt Fig. 2 Strom-Spannungskennlinien der inversen Halbleitersicherungen auf p-dotiertem ersten Halbleitergebiet mit n-dotiertem zweiten Halbleitergebiet vor und nach dem Durchlegieren. Dabei sind beispielhaft Diodenkennlinie vor dem Auslösen 11, 12 und niederohmiger, ohmscher Kurzschluss nach dem Durchlegieren 13, 14 gezeigt. Dabei wurde eine Auslösezeit kleiner als 10s und eine Auslösetemperaturbereich zwischen 400 und 750°C gewählt oder angenommen.

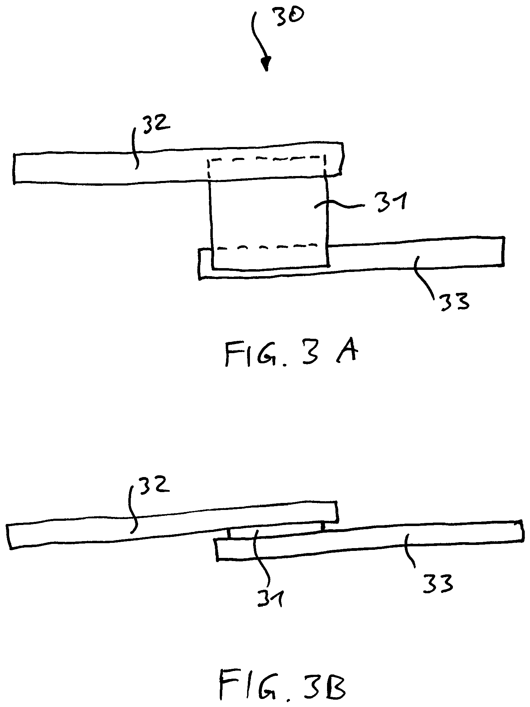

Fig. 3a und 3b zeigen eine schematische Darstellung einer Vorrichtung 30 zur Überbrückung eines elektrischen Energiespeichers in Form von einer Batteriezelle oder Akkumulatorzelle gemäß einem Ausführungsbeispiel. Die Vorrichtung 30 umfasst eine auf einem Halbleiterchip 31 integrierte Halbleiterdiode und ein erstes elektrisch leitfähiges Anschlusselement 32, das mit einer ersten Anschlussstruktur der Halbleiterdiode auf einer Vorderseite des Halbleiterchips 31 verbunden ist. Ferner umfasst die Vorrichtung 30 ein zweites elektrisch leitfähiges Anschlusselement 33, das mit einer zweiten Anschlussstruktur der Halbleiterdiode auf einer Rückseite des Halbleiterchips 31 verbunden ist. Dabei erstreckt sich ein Kontaktbereich zwischen dem zweiten elektrisch leitfähigen Anschlusselement 33 und der Rückseite des Halbleiterchips 31 über weniger als 70% der Fläche der Rückseite des Halbleiterchips 31.

Durch die Reduktion der Kontaktfläche zwischen dem Rückseitenanschluss des Überbrückungselements kann die Wärmeabfuhr über den Rückseitenanschluss deutlich reduziert werden. Dadurch kann mit geringerem Strom über die Halbleiterdiode eine schnellere oder größere Erwärmung erreicht werden. Beispielsweise kann auf diesem Weg vereinfacht die Halbleiterdiode zumindest teilweise durchzulegieren und ein nierderohmiger Strompfad erzeugt werden. So kann das Auslösen des Überbrückungselements einfacher, schneller und/oder zuverlässiger erfolgen.

Der Halbleiterchip 31 kann eine in unterschiedlichen Halbleitertechnologien (z.B. Silizium, Siliziumcarbid oder Galliumarsenid) und mit unterschiedlichem Aufbau (z.B. PN-Diode, PIN-Diode, Schottky-Diode) hergestellte Halbleiterdiode aufweisen. Ferner kann der Halbleiterchip 31 die erste und zweite Anschlussstruktur umfassen.

Das erste elektrisch leitfähige Anschlusselement 32 stellt einen elektrischen Kontakt zu der Vorderseitenelektrode oder ein oder mehreren Vorderseitenanschlusspads des Halbleiterchips 31 her, die durch die erste Anschlussstruktur gebildet werden. Das erste elektrisch leitfähige Anschlusselement führt beispielsweise aus einem Gehäuse der Vorrichtung hinaus, um einen extern zugänglichen Anschluss des Überbrückungselements zu schaffen.

Das zweite elektrisch leitfähige Anschlusselement 33 stellt einen elektrischen Kontakt zu der Rückseitenelektrode oder ein oder mehreren Rückseitenanschlusspads des Halbleiterchips 31 her, die durch die zweite Anschlussstruktur (z.B. ganzflächige Rückseitenmetallisierung) gebildet werden. Das erste elektrisch leitfähige Anschlusselement führt beispielsweise aus einem Gehäuse der Vorrichtung hinaus, um einen extern zugänglichen Anschluss des Überbrückungselements zu schaffen.

Das erste elektrisch leitfähige Anschlusselement 31 und/oder das zweite elektrisch leitfähige Anschlusselement 32 können beispielsweise über eine Pressverbindung, eine Lötverbindung oder eine Bondverbindung mit der jeweiligen Anschlussstruktur des Halbleiterchips 31 verbunden sein. Z.B. kann das erste elektrisch leitfähige Anschlusselement 32 und/oder das zweite elektrisch leitfähige Anschlusselement 33 ein einstückiges Metallelement sein, das mit der jeweiligen Anschlussstruktur des Halbleiterchips 31 durch eine Lötverbindung oder eine Pressverbindung (z.B. durch Gehäuse auf den Halbleiterchip 31 gepresst, was beispielsweise wieder zerstörungsfrei lösbar wäre) verbunden ist.

Dabei erstreckt sich der Kontaktbereich zwischen dem zweiten elektrisch leitfähigen Anschlusselement 33 und der Rückseite des Halbleiterchips 31 (z.B. der Kontaktfläche mit der zweiten Anschlussstruktur) über weniger als 70% (oder weniger als 50%, weniger als 30%, weniger als 20% oder weniger als 10%) der Fläche der Rückseite des Halbleiterchips 31. Dadurch kann die Wärmeabfuhr über das gut wärmeleitfähige Anschlusselement deutlich reduziert werden, sodass sich der Halbleiterchip 31 schneller oder mit geringerem Strom erwärmen lässt.

Optional kann der Kontaktbereich zwischen dem zweiten elektrisch leitfähigen Anschlusselement 33 und der Rückseite des Halbleiterchips 31 ausschließlich in einem Randbereich des Halbleiterchips 31 angeordnet sein, wobei sich der Randbereich des Halbleiterchips 31 von einem Rand des Halbleiterchips 31 bis maximal zur Hälfte (oder maximal bis zu einem Drittel, einem Viertel, einem Fünftel oder einem Zehntel) einer Distanz zwischen Rand und Mitte des Halbleiterchips 31 erstreckt. Dadurch kann die Wärmeabfuhr in der Mitte des Halbleiterchips 31 deutlich reduziert werden.

Ferner kann beispielsweise ein neben dem Randbereich verbleibender Mittenbereich der Rückseite des Halbleiterchips 31 frei liegen, mit einer elektrisch isolierenden Struktur in Kontakt sein oder zu einem Teil frei liegen und zum anderen Teil mit einer elektrisch isolierenden Struktur in Kontakt sein.

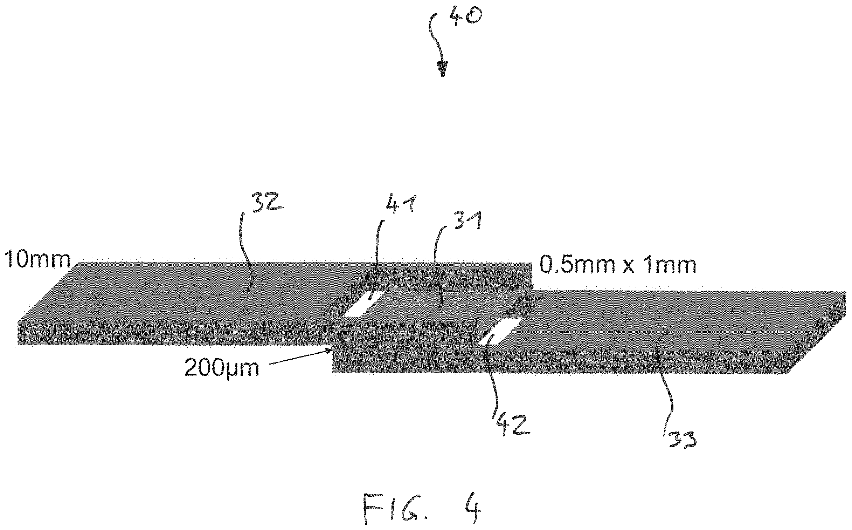

Optional kann das zweite elektrisch leitfähige Anschlusselement 33 mit zumindest zwei Zinken eines gabelförmigen Endes des zweiten elektrisch leitfähigen Anschlusselements mit der Rückseite des Halbleiterchips 31 in Kontakt sein (siehe z.B. Fig. 4).

Ferner kann sich optional auch ein Kontaktbereich, der zwischen dem ersten elektrisch leitfähigen Anschlusselement 32 und der Vorderseite des Halbleiterchips 31 über weniger als 70% (oder weniger als 50%, weniger als 30%, weniger als 20% oder weniger als 10%) der Fläche der Vorderseite des Halbleiterchips 31 erstrecken.

In einem Beispiel können sich der Kontaktbereich zwischen dem zweiten elektrisch leitfähigen Anschlusselement 33 und der Rückseite des Halbleiterchips 31 liegt, und der Kontaktbereich, der zwischen dem ersten elektrisch leitfähigen Anschlusselement 32 und der Vorderseite des Halbleiterchips 31 liegt, symmetrisch gegenüberliegen.

Die Halbleiterdiode kann beispielsweise nach dem zuvor beschriebenen Konzept oder nach einem der zuvor oder nachfolgend beschriebenen Ausführungsbeispiele (z.B. Fig. 1) implementiert sein.

Mehr Details der Vorrichtung 30 (z.B. erste Anschlussstruktur, zweite Anschlussstruktur und/oder Halbleiterdiode) und/oder zusätzliche optionale Aspekte sind in Zusammenhang mit dem vorgeschlagenen Konzept oder einem oder mehreren der zuvor oder nachfolgend beschriebenen Ausführungsbeispiele gezeigt (z.B. Fig. 1).

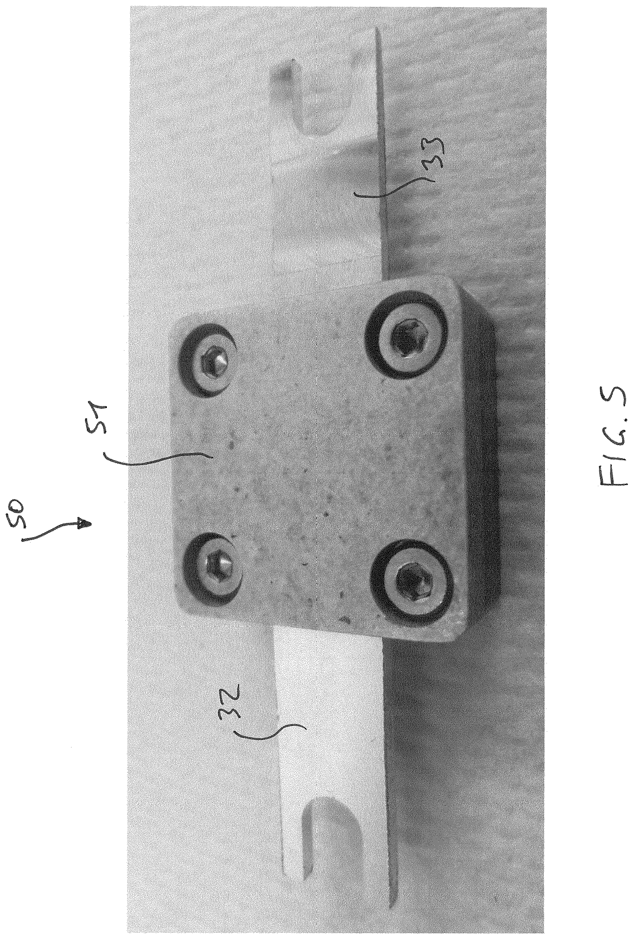

Fig. 4 zeigt beispielsweise einen weiteren möglichen Aufbau einer inversen Sicherung mit der zuvor beschriebenen Halbleiterdiode. Hier ist zu berücksichtigen, dass durch den im folgenden beschriebenen Aufbau die Ableitung von Verlustleistung eingeschränkt werden kann, wie sie beim Auslösen auftritt. Ein mögliches Kontaktierungsschema und ein entsprechendes Gehäuse 51 sind in den Figuren 4 und 5 dargestellt. Dabei zeigt Fig. 4 beispielsweise ein Kontaktierungsschema für eine inverse Sicherung und Fig. 5 ein aufgebautes Sicherungselement (Überbrückungselement) in einem Gehäuse 51 aus z.B. K-Therm® AS 600 M oder einem anderen Material.

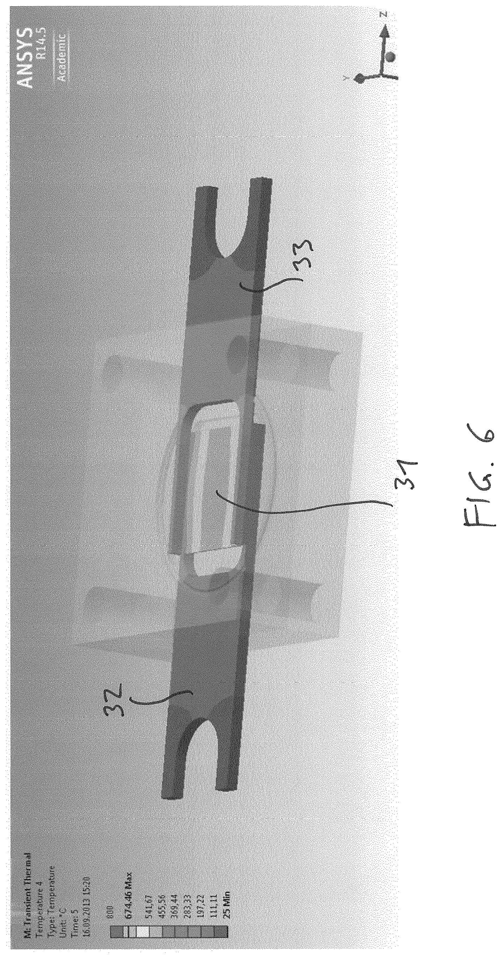

Durch die lokale Positionierung der Klemmen am Rand des Bauelements kann die Wärmeabfuhr in der Mitte des Bauelements behindert werden. Damit kann diese inverse Sicherung in kürzerer Zeit mit weniger Energie (Auslösestrom) aktiviert werden. Die Metallklemmen können dabei so positioniert werden, dass wesentlich Einfluss auf die Wärmeverteilung genommen werden kann. Die Metallklemmen (Anschlusselement) sind in diesem Fall z.B. aus Aluminium ausgeführt. In einer weiteren Ausführung können z.B. Kupferschienen zum Einsatz kommen. Außerdem ist das Ergebnis einer thermischen Simulation zur Illustration in Fig. 6 gezeigt. Fig. 6 zeigt eine simulierte Temperaturverteilung der inversen Sicherung im Aufbau einschließlich des Gehäuses. Dabei ist das Gehäuse aus FR4-Material und es wird ein 200µm dünnes Siliziumelement bei 70W Leistung für 5s (entspricht etwa 100 A, Stromdichte 100 A/cm2 Flussstrom) belastet.

Die für das Legieren des Aluminiums in Silizium notwendige Temperatur von z.B. über 580°C, bei der ein Durchlegieren innerhalb von ca. 10 s erzielt werden kann, konnte damit auf einem Großteil der Chipfläche für eine hinreichend lange Zeit erreicht werden.

Das beschriebene Bauelement kann z.B. mit einer sehr einfachen Halbleiterkomponente (pn-Übergang) realisiert werden, kann ohne externe Beschaltung (zweipoliges Überbrückungselement) auslösen, kann ohne externe Energiequelle und ohne exotherme Reaktion auslösen und/oder mit einem günstigen Herstellungsprozess (z.B. für ein Halbleiterbauelement) gefertigt werden. Ferner kann ein robustes Bauelement mit einfacher Aufbautechnologie implementiert und eine hohe Zuverlässigkeit von Halbleiterbauelementen (z.B. Spannungszyklen, Spannungsfestigkeit und ESD-Festigkeit) genutzt werden. Ferner kann das Überbrückungselement den Stromfluss bei starker Überladung der Batteriezelle (Zenerdiode in Sperrrichtung) übernehmen und so eine zusätzliche Sicherungsfunktion bieten. Diese Sicherungsfunktion kann beispielsweise schon bereitgestellt werden, ohne das Überbrückungselement auszulösen (ohne Zerstörung des pn-Übergangs). Zusätzlich kann beispielsweise ein geringer Auslösestrom, bei dem das Bauelement nicht vollständig durchlegieren muss, verwendet werden. Die Sperrspannung der Zener-Diode kann beispielweise durch die Dotierungskonzentration in den Dotierungsgebieten eingestellt werden.

Einige Ausführungsbeispiele beziehen sich auf ein Überbrückungselement auf Halbleiterbasis und ein Herstellungsverfahren für das Element und eine Vorrichtung zum Aufbau des Überbrückungselements.

Das vorgeschlagene Konzept basiert auf einer Halbleiterdiode und einem Gehäuse zur Verwendung als Überbrückungselement. Das Überbrückungselement ist beispielsweise selbstauslösend und besitzt z.B. nur zwei Pole.

Nachfolgend sei die Zuverlässigkeit von Energiespeicherpaketen in elektrischen Fahrzeugen beispielhaft näher betrachtet. In elektrischen, aber auch in hybriden Fahrzeugen liefern Energiespeicherpakete beispielsweise eine Spannung im Bereich von etwa 400V. Diese hohe Spannung kann erforderlich sein, um den Strom auf einem akzeptablen Wert zu halten, beispielsweise bei 200A, der erforderlich ist, um den/die elektrischen Antrieb(e) zu versorgen. Das Energiespeicherpaket kann daher mehrere Module umfassen, die jeweils in Reihe verschaltete Energiespeicherzellen aufweisen, z.B. Batterien, Akkumulatoren, Kondensatoren, Supercaps. Bei manchen Energiespeicherpaketen, die beispielsweise Li-Ionen-Batteriezellen verwenden, kann es für das Erreichen der oben erwähnten 400V erforderlich sein, etwa 100 dieser Li-Ionen-Batteriezellen in Reihe zu verschalten, wobei jede der Zellen etwa 2,3V-4,2V bereitstellt. Ein Problem dieser Energiespeicherpakete kann in deren begrenzter Zuverlässigkeit über eine längere Zeitdauer bestehen, was auf die hohe Anzahl von in Reihe verschalteten Zellen zurückzuführen ist. Fällt eine Zelle aus, stellt diese einen hochohmigen Pfad, beispielsweise einen Leerlauf, für den Leistungspfad dar, so dass das gesamte Energiespeicherpaket nicht mehr in der Lage ist, die von dem elektrischen Antrieb zur Bewegung des Fahrzeugs erforderliche Leistung bereitzustellen. Die Zuverlässigkeit des Fahrzeugs ist in diesem Beispiel direkt abhängig von der schwächsten Zelle innerhalb des Energiespeicherpakets.

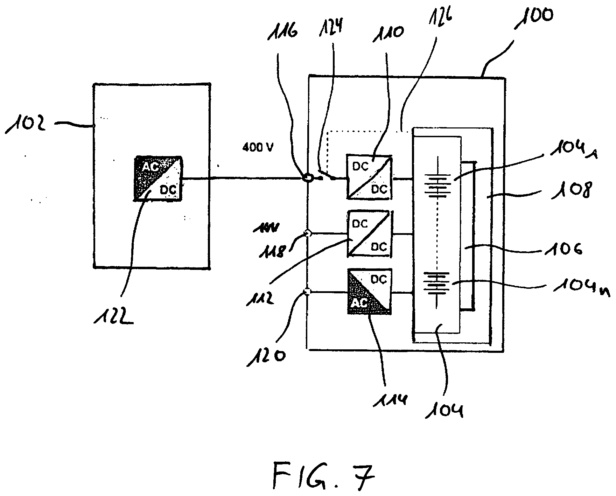

Diese Problematik sei nachfolgend anhand der Fig. 7 erläutert. Fig. 7 zeigt ein Energiespeicherpaket 100, welches mit einem elektrischen Antrieb 102, wie er beispielsweise in einem Elektrofahrzeug zum Einsatz kommt, gekoppelt ist. Das Energiespeicherpaket 100 umfasst einen Batterieblock 104, der eine Vielzahl von in Reihe geschalteten Batteriezellen 104₁ bis 104ₙ aufweist. Zusätzlich ist eine Ausgleichsschaltung 106 vorgesehen, um einen gleichmäßigen Ladezustand der einzelnen Zellen 104₁ bis 104ₙ sicherzustellen. Ferner umfasst der Batterieblock 104 eine Batterieüberwachungs- und -handhabungseinheit 108, die vorgesehen ist, um während des Betriebs die Funktion des Batterieblocks 104 zu überwachen. Das Energiespeicherpaket 100 umfasst ferner einen ersten Gleichstromwandler 110 und einen zweiten Gleichstromwandler 112, die mit dem Batterieblock 104 verbunden sind. Ferner ist ein Wechselrichter 114 vorgesehen, der ebenfalls mit dem Batterieblock 104 verbunden ist. Der erste Gleichstromwandler 110 ist ausgelegt, um an einem ersten Ausgang 116 des Energiespeicherpakets 100 eine Spannung von 400V bereitzustellen. Der zweite Gleichstromwandler 112 ist vorgesehen, um an einem zweiten Ausgang 118 eine Spannung von 14V bereitzustellen. Der Wechselrichter 114 stellt an einem dritten Ausgang 120 eine Wechselspannung bereit. Bei dem in Fig. 1 gezeigten Beispiel ist der erste Eingang 116 des Energiespeicherpakets 100 mit dem elektrischen Antrieb 102 verbunden, der seinerseits einen Wechselrichter 122 umfasst, um basierend auf der von dem Energiespeicherpaket 100 bereitgestellten Gleichspannung am Ausgang 116 eine Wechselspannung für den Betrieb des elektrischen Antriebs 102 bereitzustellen. Bei dem in Fig. 7 gezeigten Beispiel ist in dem Energiespeicherpaket 100 ferner ein Schalter 124 zwischen dem ersten Gleichstromwandler 110 und dem Ausgang 116 angeordnet, der über eine Steuerleitung 126 mit der Schaltung 108 des Batterieblocks 104 verbunden ist. Dieser Schalter kann vorgesehen sein, um für den Fall, dass am Ausgang 116 durch die Schaltung 108 kein angeschlossenes Element erkannt wird, den Ausgang 116 vom Gleichstromwandler 110 zu trennen. Wird durch die Schaltung 108 erkannt, dass am Ausgang 116 ein Element, z.B. der Antrieb 102, angeschlossen ist, so wird der Schalter 124 durch Ausgabe eines entsprechenden Steuersignals über die Leitung 126 geschlossen.

Neben den oben erwähnten Zuverlässigkeitsvoraussetzungen sind im Zusammenhang mit Energiespeicherpaketen für elektrische Fahrzeuge auch Sicherheitsaspekte zu beachten. Bei einem Energiespeicherpaket, welches eine Vielzahl von Batteriezellen aufweist, kann es aus verschiedenen Gründen dazu kommen, dass eine der Batteriezellen überhitzt. Dies bewirkt, dass deren Separator, der typischerweise aus einem Kunststoff hergestellt ist, zerstört wird oder schmilzt. Im schlimmsten Fall kann dies zu einem Kurzschluss zwischen den beiden Elektroden der Batteriezelle führen. Interne Kurzschlüsse können auch aufgrund eines Dendrit- oder Kristall-Wachstums an den Elektroden auftreten, beispielsweise wenn die Batteriezelle überladen wurde. Unglücklicherweise bieten externe Schaltungen keinen Schutz gegen solche internen Kurzschlüsse, dieser kann nur innerhalb der Batteriezelle selbst erreicht werden. Sobald aber ein interner Kurzschluss aufgetreten ist, kann durch externe Maßnahmen nicht mehr viel getan werden, um die Batteriezelle zu schützen. Ein Auftreten eines solchen Kurzschlusses kann beispielsweise durch das Erfassen eines plötzlichen Abfalls der Zellspannung erfasst werden. Diese Erfassung kann ausgenutzt werden, um einen Unterbrecher auszulösen, der die Batterie vom Rest des Pakets trennt. Interne Kurzschlüsse treten jedoch selten auf, da mittlerweile verschiedene Separatoren entwickelt wurden, die dieses Problem vermeiden.

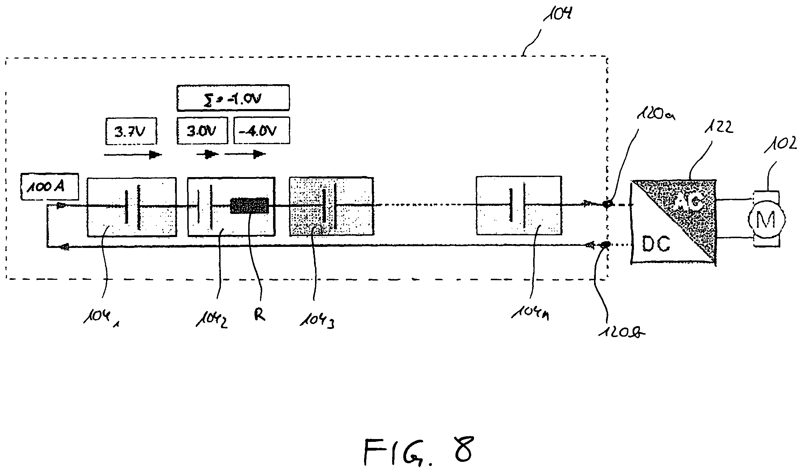

Ein Typ von Separatoren, der in Batteriezellen verwendet wird, ist ein sogenannter "Abschaltseparator". In Li-Ionen-Batteriezellen, wie sie im Automobilbereich Einsatz finden, werden Abschaltseparatoren oder Abschalttrennelemente verwendet, die innerhalb eines engen Temperaturbereichs zwischen 120° Celsius und 140° Celsius irreversibel aktiviert werden, was zu einem plötzlichen Anstieg des Serienwiderstands der Batteriezelle führt. Bei anderen Typen von Batteriezellen kann die irreversible Unterbrechung durch ein Stromunterbrechungsgerät oder eine thermische Sicherung herbeigeführt werden. All diese Schutzmechanismen bewirken einen Schaltungsunterbrechungseffekt, der dazu führt, dass die Impedanz der Batteriezelle auf bis zu einige hundert Kiloohm ansteigt. Dies bedeutet, dass der Hochstrompfad, der sich durch das Energiespeicherpaket zu dem elektrischen Antrieb erstreckt, einen erhöhten Widerstand aufweist. Dies wird nachfolgend anhand der Fig. 8 erläutert.

In Fig. 8 ist ein Energiespeicherpaket ähnlich dem, welches anhand der Fig. 7 beschrieben wurde, gezeigt, wobei die verwendeten Batteriezellen Abschaltseparatoren aufweisen. Im Fall des Überhitzens einer Batteriezelle führt der Abschaltseparator zu einer Erhöhung des Serienwiderstands, was zu einem Leerlauf führt, was weiterhin dazu führt, dass der Strompfad unterbrochen wird und der elektrische Antrieb nicht länger versorgt werden kann. In Fig. 8 ist schematisch der Batterieblock 104 gezeigt, der die Mehrzahl von Batteriezellen 104₁, 104₂, 104₃ ... 104ₙ umfasst. Die von den Batterien 104 bereitgestellte Energie dient dazu, einen elektrischen Antrieb 102 zu versorgen, wobei die von den Batterien bereitgestellte Energie mittels des Wechselrichters 122 in eine Wechselspannung zum Betrieb des Motors 102 umgewandelt wird. Die Batteriezellen 104₁, bis 104ₙ sind in Serie geschaltet, und geben an einem Ausgang 120a die Gleichleistung an den Wechselrichter 122 aus. Der Wechselrichter 122 ist ferner mit einem weiteren Eingang 120b des Batterieblocks 104 verbunden. Bei dem in Fig. 8 gezeigten Beispiel werden Li-Ionen-Batterien verwendet, wobei angenommen sei, dass mit Ausnahme der Batteriezelle 104₂ alle anderen Batteriezellen ordnungsgemäß arbeiten. Die Batteriezellen sind mit einem Abschalttrennelement bzw. Abschaltseparator versehen, wie es oben erläutert wurde. In der fehlerhaften Batteriezelle 104₂ wird aufgrund der Überhitzung der Abschaltseparator aktiviert, was zu einer Erhöhung des internen Widerstands der Batterie 104₂ führt, wie dies schematisch durch den Widerstand R gezeigt ist. Dies führt dazu, dass anstelle der von einer normal arbeitenden Batterie bereitgestellten Spannung in Höhe von etwa 3,7V aufgrund der Erhöhung des Serienwiderstands des Batterieelements 104₂ die Batterie von einer Energiequelle zu einem Energieverbraucher wird. Die Batteriezelle 104₂ stellt noch etwa 3,0V bereit, jedoch führt der erhöhte Serienwiderstand dieser Zelle zu einem Spannungsabfall von etwa 4,0V, so dass in Summe über die Zelle 104₂ eine Spannung abfällt (etwa 1V). Mit ansteigendem Serienwiderstand R der schwachen Batteriezelle 104₂ steigt deren Temperatur ebenfalls an, nachdem der Wechselrichter 122 bei einer Beschleunigung des Motors 102 als Stromsenke wirksam ist, und bei einem Abbremsvorgang des Motors als Stromquelle wirksam ist, wobei in diesem Fall die Energie über den Anschluss 120b in den Batterieblock 104 zurückgespeist wird.

In den in Fig. 7 und 8 gezeigten Beispiel kann zu einem oder mehreren der Batteriezellen 104₁, 104₂, 104₃ ... 104ₙ ein oder mehrere Überbrückungselemente nach dem vorgeschlagenen Konzept oder einem oder mehreren der zuvor genannten Ausführungsbeispiele in parallel implementiert werden. Durch die Verwendung einer vorgeschlagenen Vorrichtung zur Überbrückung eines elektrischen Energiespeichers kann die Betriebssicherheit und/oder Zuverlässigkeit des Energiespeicherpakets oder des Batteriemoduls erhöht werden.

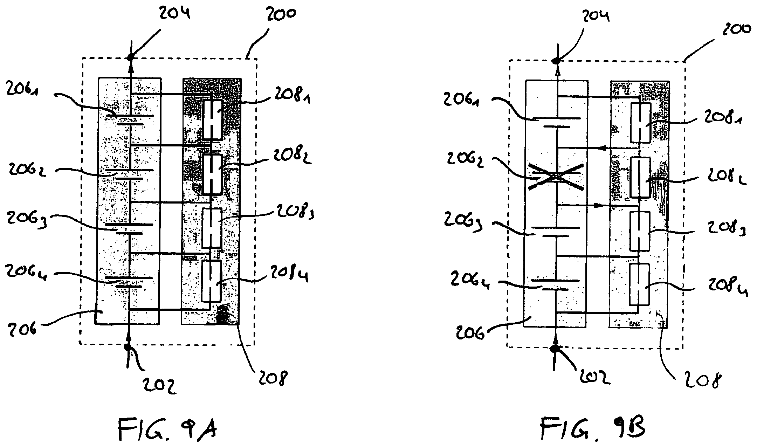

Um die oben anhand der Fig. 8 beschriebene Problematik beim Ausfall einer Batteriezelle zu lösen, kann beispielsweise ein elektrisches Leistungselement eingeführt werden, die sogenannte Power-Antifuse (Leistungs-Antifuse, inverse Sicherung), oder ein Überbrückungselement nach dem beschriebenen Konzept oder einem der Ausführungsbeispiele eingeführt werden. Die inverse Sicherung oder das Überbrückungselement kann es ermöglichen, in Reihe geschaltete Leistungselemente, beispielsweise Energiequellen in Form von Batterien, Akkumulatoren, Kondensatoren, Super/Ultra-Kondensatoren, Solarzellen oder Brennstoffzellen im Falle eines Fehlers hart kurzzuschließen. Fig. 9 zeigt in Reihe geschaltete Energiequellen mit überbrückenden Leistungselementen oder Überbrückungselementen, die eine defekte Energiequelle im Fehlerfall hart kurzschließen, so dass ein angeschlossener Energieverbraucher weiter mit Strom versorgt werden kann, wobei Fig. 9(a) eine Reihe von Energiequellen zeigt, die alle im Normalbetrieb arbeiten, und Fig. 9(b) zeigt eine Situation, bei der eine der Energiequellen fehlerhaft ist.

In Fig. 9(a) ist ein Batterieblock 200 gezeigt, der einen ersten Anschluss 202 und einen zweiten Anschluss 204 umfasst. Zwischen den Anschlüssen 202 und 204 ist eine Reihenschaltung 206 einer Mehrzahl von Batteriezellen 206₁ bis 206₄ gezeigt. Zwischen den Anschlüssen 202 und 204 ist ein Leistungspfad durch die in Reihe geschalteten Batterien 206₁ bis 206₄ definiert, wobei die in Reihe geschalteten Batterien auch als gestapelte Zellen bezeichnet werden. Der Batterieblock 200 umfasst ferner einen Sicherungsblock 208 mit einer Mehrzahl von inversen Sicherungselementen oder Überbrückungselementen 208₁ bis 208₄, wobei jedes der inversen Sicherungselemente oder Überbrückungselemente zwei Anschlüsse aufweist, von denen ein erster Anschluss mit einem ersten Anschluss oder einem ersten Pol einer Batteriezelle verbunden ist, und ein zweiter Anschluss mit einem zweiten Anschluss und einem zweiten Pol der entsprechenden Batteriezelle verbunden ist. Die inversen Sicherungselemente oder Überbrückungselemente 208₁ bis 208₄ sind den jeweiligen Batteriezellen 206₁ bis 206₄ zugeordnet, und, wie in Fig. 9(a) gezeigt ist, ist jeweils ein inverses Sicherungselement parallel zu einer oder mehrere Batteriezellen, die in Serie oder in Parallel geschaltet sind, geschaltet. In Fig. 9(a) ist die Situation dargestellt, in der alle Batteriezellen im Normalbetrieb arbeiten, so dass keines der inversen Sicherungselemente oder Überbrückungselemente aktiviert ist. Der deaktivierte Zustand der Sicherungselemente 208₁ bis 208₄ ist in Fig. 9(a) durch die unterbrochene Linie in dem Schaltungssymbol schematisch dargestellt.

Fig. 9(b) zeigt eine Situation, bei der die Batteriezelle 206₂ fehlerhaft ist. Ein solcher fehlerhafter Betrieb der Speicherzelle 206₂ führt bei Fließen eines ausreichend hohen Laststroms zu einer Umkehr der Polarität an den entsprechenden Anschlüssen der Batteriezelle. Aufgrund dieser Spannungsumkehr wird eine Aktivierung des zugeordneten inversen Sicherungselements oder Überbrückungselement 208₂ bewirkt (z.B. das Element wird ausgelöst bei Auftreten der vordefinierten Auslösekonditionen), an dessen Anschlüssen nun auch die Spannung mit umgekehrter Polarität anliegt, was in Fig. 9(b) durch die durchgezogene Linie im Element 208₂ schematisch dargestellt ist. Die anderen Elemente verbleiben in ihrem inaktiven Zustand. Wie durch die Pfeile in Fig. 9(b) dargestellt ist, erstreckt sich der Leistungspfad nunmehr vom Anschluss 202 über die Batteriezellen 206₄ und 206₃ durch das Element 208₂ und über die Batteriezelle 206₁ zu dem zweiten Anschluss 204.

Der erzeugte, niederohmige Kurzschluss kann den Ausfall des Gesamtsystems vermeiden und den weiteren Betrieb in einem verschlechterten oder reduzierten Modus ermöglichen, bis zur nächsten Wartung. Grundsätzlich können alle Arten von Systemen, die eine Reihenschaltung von Energiequellen benötigen und damit einen kritischen Strompfad aufweisen, dessen Unterbrechung zum Ausfall des Gesamtsystems führt, von der inversen Sicherung oder einem Überbrückungselement nach dem vorgeschlagenen Konzept oder einem der Ausführungsbeispiele profitieren, welche, wie erwähnt, die Zuverlässigkeit und die Verfügbarkeit des Gesamtsystems erhöht. Durch Einsatz der inversen Sicherung oder des Überbrückungselements ist die Ausfallwahrscheinlichkeit des Gesamtsystems beispielsweise nicht mehr gleich der Summe der Ausfallwahrscheinlichkeiten der einzelnen Energiequellen. Durch zusätzliche, in Reihe geschaltete Energiequellen, wie beispielsweise weitere Batteriezellen, kann mittels der inversen Sicherung oder dem Überbrückungselement ein redundantes Gesamtsystem geschaffen werden.

Beispielsweise existieren zwei Auslegungen für eine inverse Sicherung oder ein Überbrückungselement, eine sogenannte ungetriggerte Version und eine sogenannte getriggerte Version. Die ungetriggerte Version arbeitet beispielsweise ohne zusätzliche Steuersignale und umfasst lediglich die zwei für die Verbindung mit dem zu überbrückenden Element erforderlichen Leistungsanschlüsse. Die getriggerte Version kann durch ein zusätzliches Steuersignal ausgelöst werden und umfasst dabei beispielsweise einen zusätzlichen Steuereingang.

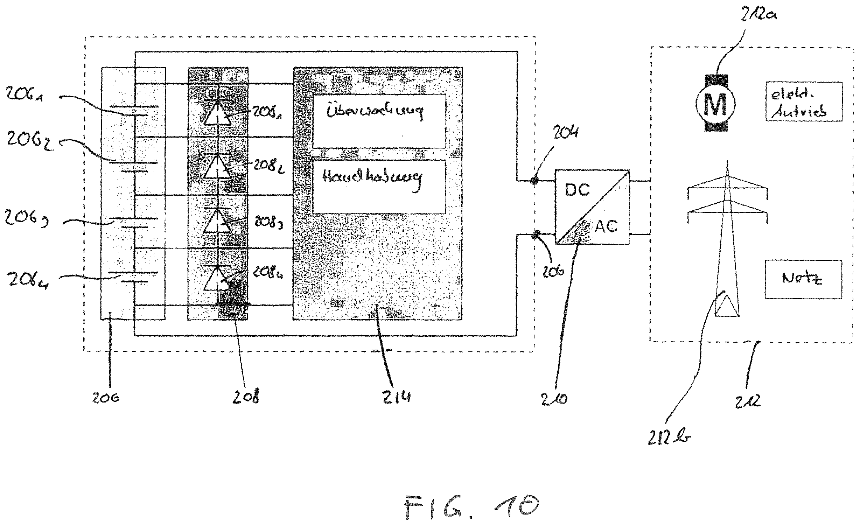

Anhand der Fig. 10 wird ein System beschrieben, welches inverse Sicherungen oder Überbrückungselement umfasst, wobei eine inverse Sicherung einer Zelle aktiviert wird, wenn sich die Zellspannung während einer Entladung aufgrund eines anwachsenden inneren Zellenwiderstandes umkehrt, ein Zustand, der bei Batterieblöcken auftreten kann, wie dies oben anhand der Fig. 8 erläutert wurde. Die Fig. 10 zeigt den Batterieblock 200 mit den Anschlüssen 202 und 204, an die ein bidirektionaler Wechselrichter 210 angeschlossen ist, der eine Wechselleistung an die in Fig. 10 schematisch dargestellte elektrische Last 212 bereitstellt. Die in Fig. 10 gezeigte elektrische Last 212 umfasst beispielsweise einen elektrischen Antrieb oder Elektromotor 212a oder ein Leistungsnetz 212b, in das eine Wechselleistung einzuspeisen ist. Der Batterieblock umfasst zusätzlich zu der Reihenschaltung 206 der Batteriezellen 206₁ bis 206₄ ein Batteriezellenüberwachungs- und Handhabungssystem 214. Ferner sind in Fig. 10 die inversen Sicherungselemente bzw. Überbrückungselemente 208₁ bis 208₄ gezeigt, die parallel zu den entsprechenden Batteriezellen geschaltet sind und alle im deaktivierten Zustand sind, wie dies durch die unterbrochene Linie in dem Schaltungssymbol gezeigt ist. Die Überwachungsschaltung 214 ist mit jeder der Parallelschaltungen umfassend eine Batteriezelle und ein Überbrückungselement verbunden, und ermöglicht neben den herkömmlichen, bekannten Funktionen ferner eine Überwachung, die feststellt, welche der Zellen fehlerhaft ist, um eine entsprechende Anzeige zu liefern, die eine Wartung erleichtern.

Um eine fehlerhafte Zelle ohne signifikante Erhöhung der Kosten des Gesamtbatterieblocks zu überbrücken, kann eine inverse Sicherung oder ein Überbrückungselement nach dem vorgeschlagenen Konzept eingesetzt werden, bei der es sich um ein Bauelement handelt, welches sich im Wesentlichen wie ein offener Zustand verhält, wenn es nicht aktiviert wurde, und welches eine niedrige Impedanz bzw. einen Kurzschluss mit hoher Stromkapazität aufweist, wenn es aktiviert wurde, wobei das Element bei seiner Aktivierung einmalig und irreversibel von dem offenen Zustand in den Kurzschlusszustand übergeht, ein Übergang zurück in den offenen Zustand ist also beispielsweise nicht möglich. Die vorgeschlagene inverse Sicherung ermöglicht beispielsweise eine dynamische Rekonfiguration von Batterieblöcken im Fall einer fehlerhaften Zelle. Ohne die inversen Sicherungselemente würde der Strompfad (siehe beispielsweise Fig. 8) unterbrochen und die elektrische Last könnte nicht länger mit Energie versorgt werden.

Ein Aspekt schafft somit ein Konzept umfassend die inverse Sicherung, die die fehlerhafte Zelle in einem Stapel kurzschließt, um diese aus dem Leistungs/Strom-Pfad zu entfernen, so dass unter Anwendung einer solchen Lösung das Gesamtsystem immer noch arbeiten kann und eine Last mit Energie bzw. Strom versorgen kann.

Die in Fig. 10 gezeigten Batteriezellen 206₁ bis 206₄ verwenden interne Kurzschlussschutzmechanismen, beispielsweise einen Abschaltseparator, die irreversibel aktiviert werden, wenn die Batteriezelle überhitzt. Dies verhindert eine Explosion der Batteriezelle und eine Beschädigung von Nachbarzellen. Wenn der Abschaltseparator aufgrund eines Kurzschlusses aktiviert wurde, der durch die aktivierte inverse Sicherung herbeigeführt wurde, verhält sich die fehlerhafte Batteriezelle wie ein hochresistiver Widerstand im Leistungspfad. Durch Verwendung des inversen Sicherungselements ist der Wechselrichter 210 jedoch weiterhin in der Lage, der Last 212 Energie von den verbleibenden, gesunden Batteriezellen zuzuführen, nachdem die fehlerhafte Zelle mittels der inversen Sicherung überbrückt wurde, wie dies anhand der Fig. 9 erläutert wurde.

Die allen Batteriezellen gemeinsame Überwachungs- und Handhabungsschaltung 214 existiert beispielweise für Energiespeicherpakete für Elektrofahrzeuge. Das Überwachungssystem überwacht die Spannung jeder Zelle. Falls eine Zelle eine verdächtige Spannung zeigt, wird dies durch das System erkannt, so dass eine Wartung vereinfacht wird oder das entsprechende Überbrückungselement aktiv ausgelöst wird.

Für den störungsfreien Betrieb der Akkumulatorzellen im Normalbetrieb kann beispielsweise ein hochohmiger Widerstand der inaktiven inversen Sicherung erforderlich sein, um eine Selbstentladung der Batteriezellen über die inverse Sicherung zu vermeiden. Im Ausfallbetrieb hingegen würde beispielsweise ein zu hoher Durchlasswiderstand der ausgelösten inversen Sicherung den maximal aus den restlichen Zellen entnehmbaren Strom (ca. 100A bis 200A) zu stark begrenzen, und ferner wäre ein erheblicher Aufwand für das Ableiten der thermischen Verlustleistung erforderlich (ca. 10W Spitzenleitverluste in der inversen Sicherung). Ausführungsbeispiele schaffen beispielsweise eine inverse Sicherung, die einen Widerstandshub von einigen Größenordnungen zwischen dem Ausfall- und Normalbetrieb aufweist. Dies kann erforderlich sein, da eine abrupte Dissipation der verbleibenden Energie einer fälschlicherweise als defekt identifizierten Zelle durch die hohe Verlustenergie zu einer Überhitzung und Beschädigung benachbarter Zellen führen könnte.

Aufgrund der hohen Stromstärken, welche in elektrischen Energiespeichern für Stationär- und Transportsysteme auftreten, kann der Einbau der inversen Sicherung möglichst nahe an der jeweiligen Zelle erfolgen, so dass für eine bauraumminimierte Realisierung die Herstellung der inversen Sicherung in Form eines integrierten Bauelements erfolgen kann. Die inverse Sicherung kann derart dimensioniert sein, dass das elektrische Verhalten des Bauelementgehäuses berücksichtigt ist und ferner eine erforderliche Stromtragfähigkeit sichergestellt ist.

Gemäß einem Aspekt kann nach dem vorgeschlagenen Konzept eine inverse Sicherung oder ein Überbrückungselement hergestellt werden, das kostengünstig hergestellt ist und sich im Fehlerfall selbst aktiviert und dann zusammen mit der defekten Akkumulatorzelle ausgetauscht werden kann. Zur Herstellung der inversen Sicherungen können integrierbare Bauelementtechnologien eingesetzt werden, wobei die inverse Sicherung eine Diodenfunktion aufweisen kann, was bedeutet, dass der Strom im Normalbetrieb nur in eine Richtung fließen kann. Diese Diodenfunktion ist antiparallel zu der zu überbrückenden Zelle angeschlossen, wie dies anhand der Fig. 10 (siehe das dort verwendete Diodensymbol) gezeigt ist. Im Fehlerfall wird diese Diodenfunktion durch einen einmaligen Stromfluss in Durchlassrichtung zerstört, so dass aus der Diodenfunktion ein bidirektionaler, symmetrischer, niederohmiger Kurzschluss wird. Diese Zerstörung der Diodenfunktion kann beispielsweise dadurch erreicht werden, dass aufgrund des einmaligen Stromflusses die Schicht bzw. die Schichten, die die Diodenfunktion definieren, durchlegieren und den Kurzschluss bilden.

Die Diodenfunktion wird erfindungsgemäß durch eine Junction-Diode mit PN-Übergang implementiert. In anderen Beispielen, die nicht Teil der Erfindung sind, kann die Diodenfunktion eine Schottky-Diode, z.B. ein Halbleiter-Metall-Übergang, oder andere für den Stromfluss unidirektionale Strukturen sein. Die Diodenfunktion kann durch verschiedene Verfahren realisiert werden, beispielsweise in Dünnschichttechnik, durch druckbare Elektronik, durch Aufsputtern und Ähnliches.

Gemäß einem Aspekt kann zur Realisierung der inversen Sicherung von dem Metal-Spiking-Phänomen Gebrauch gemacht werden, beispielsweise dem Aluminium-Spiking, welches die Durchlegierung bewirkt und im ausgelösten Zustand einen sehr niederohmigen Kurzschluss ermöglicht.

Gemäß Ausführungsbeispielen, bei denen eine Durchlegierung bereits bei niedrigen Temperaturen stattfinden soll, kann beispielsweise vorgesehen sein, Metalllegierungen in einem Eutektikum zu mischen und einzusetzen.

Eine vorgeschlagene inverse Sicherung kann beispielsweise das Verhalten eines Stromschalters aufweisen, der im offenen Zustand einen sehr geringen Leckstrom aufweist (wenn der Strom über die funktionsfähige Zelle transportiert wird), und der im geschlossenen Zustand eine sehr geringe Verlustleistung aufweist (wenn der Strom durch die inverse Sicherung über eine defekte Zelle transportiert wird). Beispielsweise können Systeme mit in Reihe geschalteten Zellen, z.B. Energiequellen, wie Batterien, Akkumulatoren, Kondensatoren, Super/Ultra-Kondensatoren, Solarzellen und Brennstoffzellen, eine Redundanz durch das Einfügen von inversen Sicherungen antiparallel zu den Energiequellen gewinnen. Es kann vermieden werden, redundante Zellen in das System einzufügen, wodurch zusätzliche Systemkosten eingespart werden können. Komplexe Schaltungen für eine dynamische Rekonfigurierbarkeit des Systems können vermieden werden, so dass auch keine zusätzlichen Systemkosten auftreten, da die inverse Sicherung sich selbst auslösen kann.

Selbst nach Ausfall von mehreren Zellen kann das System noch in einem reduzierten Modus oder degradierten Modus funktionieren. Die ausgefallenen und durch die inversen Sicherungen kurzgeschlossenen Zellen können gemäß Ausführungsbeispielen durch existierende Systeme, wie beispielsweise das oben erwähnte Überwachungssystem erkannt werden, wobei schwache Zellen bereits frühzeitig durch eine inverse Sicherung kurzgeschlossen werden können, da die inverse Sicherung entsprechend konzipiert werden kann.

Die vorgeschlagenen Sicherung kann verglichen mit herkömmlichen, aktiven Halbleiterbauelementen billiger sein und im Durchlasszustand einen deutlich geringeren Zellenwiderstand als herkömmliche aktive Halbleiterbauelemente haben. Verglichen mit anderen aktiven Halbleiterbauelementen ist der Herstellungsprozess deutlich einfacher und es können zum Auslösen der inversen Sicherung Ausfallmechanismen kontrolliert benutzt werden, die normalerweise bei Halbleiterbauelementen zu vermeiden sind, beispielsweise das oben erwähnte Aluminium-Spiking.

Über die ausgelöste inverse Sicherung kann erreicht werden, dass kein (oder nur vernachlässigbarer) Spannungsabfall stattfindet, so dass im wesentlichen nur die durch die Kontaktwiderstände entstehenden Verluste existieren. Eine eventuelle Schwellspannung, die durch die Diodenfunktion gegeben ist, ist beispielsweise im ausgelösten Zustand nicht mehr existent. Ferner ist z.B. im ausgelösten Zustand der entstehende Kurzschluss für den Strom durch die inverse Sicherung niederohmig und bidirektional, d.h. symmetrisch und es liegt keine Diodenfunktion mehr vor. Der Auslösemechanismus ist beispielsweise elektro-thermometallurgisch und irreversibel, und die zum Auslösen benötigte Wärme wird von der Restenergie der kurzzuschließenden Zelle entzogen oder durch eine Stromquelle/Senke, z.B. den Wechselrichter in Fig. 10, aus den gesunden Zellen entnommen. Ferner kann die inverse Sicherung in Zellen integriert sein, z.B. während der Fertigung in der Batteriezelle/Batterieverpackung, beispielsweise in Kombination mit einem Abschaltseparator.

Ferner kann das aktivierte Element eine Aufladung der in Reihe geschalteten Batterien ermöglichen, aufgrund seiner im ausgelösten Zustand vorliegenden Bidirektionalität.

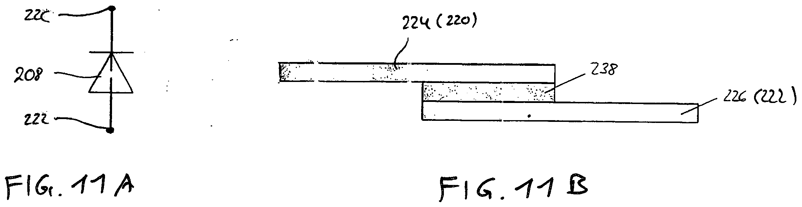

Die Fig. 11 zeigt eine schematische Darstellung einer inversen Sicherung gemäß einem Ausführungsbeispiel der Erfindung. Fig. 11(a) zeigt die in den Fig. 9 und 10 verwendeten Symbole für die inverse Sicherung 208 im nicht-ausgelösten Zustand, was durch die nichtdurchgezogene Linie in Fig. 11(a) innerhalb des Schaltungssymbols schematisch angezeigt ist. Das inverse Sicherungselement 208 umfasst einen ersten Anschluss 220 sowie einen zweiten Anschluss 222. Gemäß Ausführungsbeispielen ist der erste Anschluss 220 ein erster Leistungsanschluss, der beispielsweise zum Anschluss an eine positive Zellelektrode bzw. einen positiven Pol einer Batteriezelle vorgesehen ist. Der zweite Anschluss 222 ist ein zweiter Leistungsanschluss, der beispielsweise zum Anschluss an eine negative Zellelektrode bzw. an den negativen Pol einer Batteriezelle vorgesehen ist.

Fig. 11(b) zeigt eine schematische Darstellung des Aufbaus einer inversen Sicherung gemäß Ausführungsbeispielen. Die inverse Sicherung 208 ist ein mehrschichtiges Element, welche eine erste Metallschicht 224 und eine zweite Metallschicht 226 umfasst. Zwischen den Metallschichten 224 und 226 ist ein Element 238 angeordnet, welches eine Diodenfunktion im Normalbetrieb bereitstellt, die beim Auslösen des Elements 208 in eine dauerhafte (irreversible) leitfähige Verbindung umgewandelt wird. Das Element 238 kann eine oder mehrere stromsperrende Schichten umfassen, wobei die hierdurch realisierte, im Normalbetrieb vorliegende Diodenfunktion bei einer Umdrehung der Polarität zwischen den Metallschichten 224 und 236 irreversibel aufgehoben wird, d.h. das Element 238 geht irreversibel in einen niederohmigen Zustand über. Die Metallschichten 224 und 238 bilden die ersten und zweiten Anschlüsse 220 und 222 des inversen Sicherungselements 208, die in Fig. 11(a) dargestellt sind, und werden mit den oben erwähnten entsprechenden Anschlüssen einer Batterie bzw. einer Energiequelle verbunden.

Wie aus Fig. 11 zu erkennen ist, umfasst das vorgeschlagene inverse Sicherungselement die zwei Leistungsanschlüsse 220(224) und 222(226), beispielsweise in Form metallischer Elektroden. Aufgrund der zwischen den Metallelektroden 234 und 236 angeordneten Einheit 238 in Form einer oder mehrerer Schichten, werden zwei stabile Zustände des Sicherungselements erreicht, nämlich ein erster Zustand, in dem beide Leistungsanschlüsse 220 und 222 hochohmig voneinander getrennt sind bzw. ein zweiter Zustand, in dem die zwei Leistungsanschlüsse 220 und 222 kurzgeschlossen sind. Wie aus Fig. 11 zu erkennen ist, können zusätzlichen Signalanschlüsse vermieden werden. Der Auslösemechanismus kann elektrischer, thermischer oder metallurgischer Natur sein, beispielsweise kann durch das oben erwähnte Aluminium-Spiking oder durch andere Metalle, in die sich der Halbleiter bei höheren Temperaturen auflöst, der zweite stabile Zustand herbeigeführt werden.

Eine Diodenfunktion durch das Element 238 im ersten Zustand wird durch einen PN-Übergang bereitgestellt. Ferner kann zusätzlich vorgesehen sein, ein Halbleitersubstrat bzw. einen Träger vorzusehen, beispielsweise einen Silizium-Wafer, einen Siliziumcarbid-Wafer, einem GaAs-Wafer, um die Diodenfunktion zu realisieren. Die anhand der Fig. 11 gezeigte Anordnung kann beispielsweise unter Verwendung einer Dünnfilmtechnik, unter Verwendung eines Druckprozesses, unter Verwendung einer CMOS-Prozessierung oder Ähnlichem herstellt werden. Einer der Leistungsanschlüsse bzw. eine der Metallschichten 224, 226 kann als Träger während der Prozessierung des Elements 238 zur Realisierung der Diodenfunktion verwendet werden.

Das Element 238 wird durch Halbleitermaterialien realisiert, wie beispielsweise Silizium, Siliziumcarbid, GaAs, GaN und Ähnliches.

Ein Aspekt bezieht sich beispielsweise auf eine Vorrichtung zum Überbrücken einer Energiequelle, der im Normalbetrieb zwischen zwei Anschlüssen eine Spannung bereitstellt, wobei sich im Fehlerfall eine Spannung zwischen den Anschlüssen umkehrt. Die Vorrichtung umfasst ein Element, das zwischen die Anschlüsse der Energiequelle schaltbar ist, wobei das Element konfiguriert ist und mit der Energiequelle verschaltbar ist, um bei Anliegen der Spannung im Normalbetrieb eine hochohmige Verbindung zwischen den Anschlüssen der Energiequelle oder des Energieverbrauchers bereitzustellen, und um bei Anliegen der umgekehrten Spannung im Fehlerfall eine bidirektionale, symmetrische, dauerhafte und niederohmige Verbindung zwischen den Anschlüssen der Energiequelle oder des Energieverbrauchers bereitzustellen.

Ein Aspekt bezieht sich ferner auf ein Verfahren zum Überbrücken einer Energiequelle oder eines Energieverbrauchers, der im Normalbetrieb zwischen zwei Anschlüssen eine Spannung bereitstellt, wobei sich im Fehlerfall eine Spannung zwischen den Anschlüssen umkehrt. Das Verfahren umfasst bei Anliegen der Spannung im Normalbetrieb, Bereitstellen einer hochohmigen Verbindung zwischen den Anschlüssen der Energiequelle oder des Energieverbrauchers, und bei Anliegen der umgekehrten Spannung im Fehlerfall, Erzeugen einer bidirektionalen, dauerhaften und niederohmigen Verbindung zwischen den Anschlüssen der Energiequelle oder des Energieverbrauchers.

Einige Beispiele beziehen sich ferner auf eine Energiequelle oder einen Energieverbraucher, mit einem ersten Anschluss, einem zweiten Anschluss, wobei im Normalbetrieb zwischen den zwei Anschlüssen eine Spannung anliegt, und wobei sich im Fehlerfall eine Spannung zwischen den Anschlüssen umkehrt, und einer Vorrichtung gemäß Ausführungsbeispielen, die zwischen den ersten Anschluss und den zweiten Anschluss geschaltet ist.

Ausführungsbeispiele schaffen ferner eine Vorrichtung, mit zumindest zwei in Reihe geschalteten Energiequellen oder Energieverbrauchern gemäß Ausführungsbeispielen.

Gemäß weiteren Ausführungsbeispielen umfasst die Vorrichtung einen ersten Anschluss und einen zweiten Anschluss, wobei das Element zwischen dem ersten Anschluss und dem zweiten Anschluss angeordnet ist, wobei das Element konfiguriert ist, um bei Anliegen einer ersten Spannung zwischen dem ersten und zweiten Anschluss die hochohmige Verbindung zwischen dem ersten und zweiten Anschluss bereitzustellen, und um bei Anliegen einer zweiten, zu der ersten Spannung umgekehrten Spannung zwischen dem ersten und zweiten Anschluss die bidirektionale, dauerhafte und niederohmige Verbindung zwischen dem ersten und zweiten Anschluss bereitzustellen, und wobei der erste Anschluss und der zweite Anschluss derart mit den Anschlüssen der Energiequelle oder des Energieverbrauchers verbindbar sind, dass im Normalbetrieb die Spannung der Energiequelle oder des Energieverbrauchers als erste Spannung zwischen dem ersten und zweiten Anschluss anliegt, und dass im Fehlerfall die umgekehrte Spannung an der Energiequelle oder dem Energieverbraucher als zweite Spannung zwischen dem ersten und zweiten Anschluss anliegt.

Das Element kann gemäß Ausführungsbeispielen konfiguriert sein, um eine unidirektionale Stromrichtung zu erlauben bzw. eine Diodenfunktion bereitzustellen, die bei Anliegen der Spannung im Normalbetrieb die hochohmige Verbindung ermöglicht, und die bei Anliegen der umgekehrten Spannung im Fehlerfall aufgrund des fließenden Stromes zerstört wird und in einen bidirektionalen, symmetrischen niederohmigen Kurzschluss umgewandelt wird. In diesem Fall kann das Element eine oder mehrere strukturierten oder unstrukturierten Schichten umfassen, um die Diodenfunktion bereitzustellen, wobei der fließende Strom im Fehlerfall ein Durchlegieren bewirkt, so dass sich der Kurzschluss einstellt. Das Element kann konfiguriert sein, um ein Metal-Spiking (z.B. ein Aluminium-Spiking) zum Erreichen der Durchlegierung zu ermöglichen, wodurch der Kurzschluss sehr niederohmig ist. Alternativ kann das Element in einem Eutektikum gemischte Metalllegierungen umfassen, um die Durchlegierung schon bei niedrigen Schmelztemperaturen zu erreichen. Die Diodenfunktion ist durch eine Junction-Diode realisiert.

Gemäß einem Aspekt ist die Vorrichtung ohne externe Steuersignale auslösbar.

Die im Normalbetrieb anliegende Spannung hat eine erste Polarität, und die im Fehlerfall anliegende Spannung hat eine der ersten Polarität entgegengesetzte Polarität, wobei die im Normalbetrieb anliegende Spannung und die im Fehlerfall anliegende Spannung unterschiedliche Werte haben können.

Die Energiequelle kann eine Batterie, einen Akkumulator, einen Kondensator, einen Super/Ultra-Kondensator, eine Solarzelle oder eine Brennstoffzelle umfassen.

Ausführungsbeispiele schaffen beispielsweise ein Sicherungselement, das kostengünstig herzustellen ist, im aktiven Zustand Ströme von über 100A tragen kann und einen Serienwiderstand von unter 1 mΩ aufweist, und das sich im Fehlerfall selbstständig aktiviert, ohne dass eine Überspannung am überwachten Bauelement erforderlich ist.

Die Integration einer Leistungs-Antifuses parallel zu jeder Zelle kann einfach zu implementieren sein, wodurch die Zuverlässigkeit und die Lebensdauer des Gesamtenergiepakets, z.B. in elektrischen Fahrzeugen, dramatisch erhöht werden kann. Ferner kann hierdurch nicht nur eine sehr kosteneffektive Lösung zur Erhöhung der Zuverlässigkeit des Energiespeicherpakets bereitgestellt werden, sondern es werden auch die bereits vorhandenen Entwicklungen im Bereich der Überwachung und Handhabung von Energiepaketen, beispielsweise im Zusammenhang mit Batterieüberwachungs- und Handhabungssystemen, verwendet.

Ausführungsbeispiele betreffen beispielsweise ein Überbrückungselement für Akkumulatorzellen in mobilen und stationären Anwendungen, die beispielsweise Lithium-Ionen-Zellen umfassen. Eine schadhafte Lithium-Ionen-Akkumulatorzelle weist einen hohen Serienwiderstand im Stromkreis auf und erhöht damit die Verlustleistung im Gesamtsystem. Wenn dieser Serienwiderstand zu groß ist, wird in dieser schadhaften Akkumulatorzelle eine beachtliche Energiemenge als Verlustleistung verbraucht. Dies kann zur Überhitzung oder zum Brand, im schlimmsten Fall sogar zur Explosion des gesamten Hochleistungsenergiespeichers, führen. Um dieses sicherheitsrelevante Problem zu beheben, muss die schadhafte Akkumulatorzelle aus dem Energiespeicher getrennt werden, ohne den Stromkreis im Gesamtsystem zu unterbrechen. Diese Abtrennung kann beispielsweise durch das Kurzschließen der Anschlüsse bzw. Plus- und Minuspole mittels einer vorgeschlagenen inversen Sicherung erzielt werden, die im Normalbetrieb eine hohe Resistivität und im Ausfallbetrieb eine niedrige Resistivität zeigt. Der Strom wird dann nicht mehr über die schadhafte Akkumulatorzelle fließen, sondern über die inverse Sicherung, die in dem Ausfallbetrieb einen niedrigen Widerstand aufweist, der in der Größenordnung des Innenwiderstands der intakten Akkumulatorzelle oder darunter liegen kann. Hierdurch wird der Energieverlust und die auftretende Wärmeerzeugung im Fehlerfall in akzeptablen und sicheren Grenzen gehalten. Durch den Einsatz einer vorgeschlagenen inversen Sicherungen kann gewährleistet werden, dass beschädigten, fehlerhaften oder ausgefallenen Zellen im System gegen Überlastung geschützt sind. Darüber hinaus kann das System im Havariefall sogar in einem leicht verschlechterten oder degradierten Modus arbeiten, d.h. mit einer oder mehreren abgetrennten Akkumulatorzellen bzw. ausgelösten inversen Sicherungen wird immer noch ausreichend Energie bereitgestellt, die einen Betrieb des Gesamtsystems, beispielsweise eines Antriebs, ermöglicht. Im Fall des Einsatzes in Kraftfahrzeugen, kann hierdurch auch bei Ausfall einer oder mehrerer Zellen im Batterieblock sichergestellt werden, dass das betroffene Kraftfahrzeug eigenständig bis zur nächsten Werkstatt gefahren werden kann. Auch die Zuverlässigkeit von stationären Systemen, beispielsweise von Photovoltaik-Insellösungen, kann von einer vorgeschlagenen inversen Sicherung profitieren.

Bei einer Reparatur des fehlerhaften Systems ist es beispielsweise nicht länger erforderlich, den gesamten Energiespeicher auszutauschen, sondern es ist ausreichend, die als defekt erkannten Akkumulatorzellen auszutauschen, welche im Regelfall bereits vom Überwachungssystem erkannt wurden.

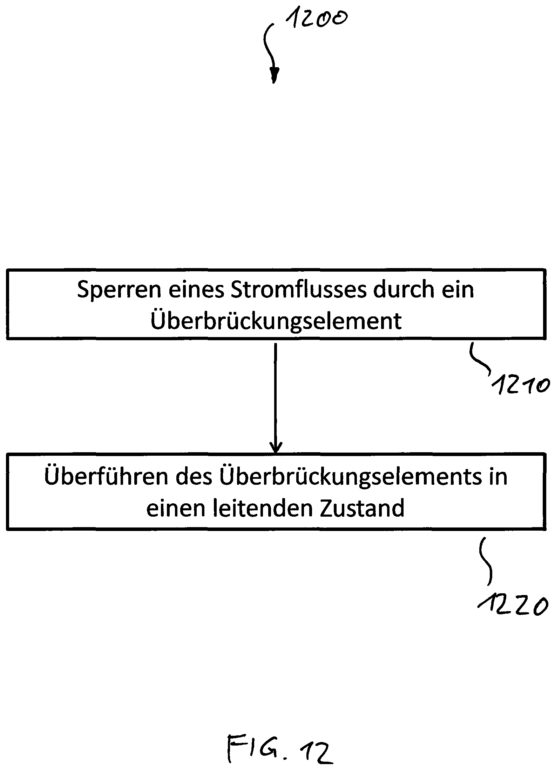

Fig. 12 zeigt ein Flussdiagramm eines Verfahrens 1200 zur Überbrückung eines elektrischen Energiespeichers in Form von einer Batteriezelle oder Akkumulatorzelle gemäß einem Ausführungsbeispiel. Das Verfahren 1200 umfasst ein Sperren 1210 eines Stromflusses durch ein Überbrückungselement, das ein Halbleitersubstrat mit einem an einer Oberfläche des Halbleitersubstrats angeordneten ersten Dotierungsgebiet und einem an das erste Dotierungsgebiet angrenzendes zweites Dotierungsgebiet aufweist. Das erste Dotierungsgebiet weist einen ersten Leitfähigkeitstyp und das zweite Dotierungsgebiet weist einen zweiten Leitfähigkeitstyp auf, wobei der pn-Übergang zwischen dem ersten Dotierungsgebiet und dem zweiten Dotierungsgebiet zumindest teilweise weniger als 5 µm von einem an der Oberfläche des Halbleitersubstrats angeordneten Anschlussbereich des ersten Dotierungsgebiets entfernt angeordnet ist. Das Überbrückungselement weist eine zumindest teilweise zur Diffusion in das Halbleitersubstrat vorgesehenes, elektrisch leitfähiges Material aufweisenden ersten Anschlussstruktur auf, die in dem Anschlussbereich des ersten Dotierungsgebiets mit dem ersten Dotierungsgebiet in Kontakt ist. Ferner umfasst das Verfahren 1200 ein Überführen 1220 des Überbrückungselements in einen leitenden Zustand bei Auftreten von vordefinierten Auslösekonditionen durch zumindest teilweises Diffundieren des zur Diffusion in das Halbleitersubstrat vorgesehenen, elektrisch leitfähigen Materials durch das erste Dotierungsgebiet bis in das zweite Dotierungsgebiet.

Durch die Verwendung des zur Diffusion in das Halbleitersubstrat vorgesehenen, elektrisch leitfähigen Materials in der Anschlussstruktur eines dünnen Dotierungsgebiets einer Diode kann das dünne Dotierungsgebiets bei Auftreten der vordefinierten Auslösebedingungen zumindest teilweise durchlegiert werden und so ein niederohmiger Strompfad erzeugt werden. Dadurch kann ein Überbrückungselement mit hoher Zuverlässigkeit und/oder geringen Kosten realisiert werden.

Das Verfahren kann ein oder mehrere weitere optionale Schritte aufweisen, die ein oder mehreren der zuvor in Verbindung mit dem beschriebenen Konzept oder einem oder mehreren der beschriebenen Ausführungsbeispielen erwähnten Aspekten entsprechen.

Einige Ausführungsbeispiele beziehen sich auf ein Verfahren zur Herstellung einer Vorrichtung zur Überbrückung eines elektrischen Energiespeichers in Form von einer Batteriezelle oder Akkumulatorzelle nach dem beschriebenen Konzept oder einem oder mehreren der zuvor beschriebenen Ausführungsbeispiele.

Die Ausführungsformen können des Weiteren ein Computerprogramm zur Verfügung stellen, das einen Programmcode zum Ausführen von einem der vorstehenden Verfahren aufweist, wenn das Computerprogramm auf einem Computer oder einem Prozessor ausgeführt wird. Ein Fachmann auf diesem Gebiet würde ohne weiteres erkennen, dass Schritte von verschiedenen vorstehend beschriebenen Verfahren durch programmierte Computer ausgeführt werden können. Einige Ausführungsformen sind hierbei auch dafür vorgesehen, Programmspeichervorrichtungen, z. B. digitale Datenspeichermedien abzudecken, die maschinenlesbar oder computerlesbar sind und von Maschinen oder von Computern ausführbare Programme von Instruktionen codieren, wobei die Instruktionen einige oder alle Schritte der vorstehend beschriebenen Verfahren ausführen. Die Programmspeichervorrichtungen können z. B. aus digitalen Speichern, magnetischen Speichermedien, wie beispielsweise magnetischen Disketten und magnetischen Bändern, Festplatten oder optisch lesbaren digitalen Datenspeichermedien bestehen. Die Ausführungsformen sind auch dafür vorgesehen, Computer abzudecken, die programmiert sind, um die Schritte der vorstehend beschriebenen Verfahren auszuführen, oder (feld-) programmierbare logische Anordnungen ((F)PLAs, (Field) Programmable Logic Arrays) oder im Anwendungs(Feld) programmierbare (Logik-)Gatter-Anordnungen ((F)PGAs, (Field) Programmable Gate Arrays), die programmiert sind, um die Schritte der vorstehend beschriebenen Verfahren auszuführen.

Die Beschreibung und die Zeichnungen veranschaulichen nur die Prinzipien der Offenbarung. Deswegen wird anerkannt, dass die Fachleute auf dem Gebiet in der Lage sein werden, verschiedene Einrichtungen zu entwerfen, die, obwohl sie hier nicht ausdrücklich gezeigt sind, die Prinzipien der Offenbarung verkörpern und im Geist und Schutzumfang der Erfindung eingeschlossen sind. Des Weiteren sind die hier vorgestellten Beispiele im Wesentlichen ausdrücklich nur zu pädagogischen Zwecken vorgesehen, um dem Leser beim Verständnis der Prinzipien der Offenbarung und der von dem(den) Erfinder(n) beigetragenen Konzepte zur Förderung der Technik zu helfen, und sie sind ohne Beschränkung auf solch speziell vorgestellten Beispiele und Bedingungen vorgesehen. Darüber hinaus sind hierbei alle Aussagen, in denen Prinzipien, Aspekte und Ausführungsformen der Offenbarung, als auch spezielle Beispiele davon angeführt werden, so vorgesehen, dass sie deren Entsprechungen mit einschließen.

Funktionelle Blöcke, die mit "Mittel zum ..." (Ausführen einer bestimmten Funktion) bezeichnet sind, sind als funktionelle Blöcke zu verstehen, die eine Schaltungsanordnung umfassen, die ausgestaltet ist, um jeweils eine bestimmte Funktion auszuführen. Deshalb kann ein "Mittel für etwas" möglicherweise ebenfalls als ein "Mittel, das ausgestaltet ist, um oder das sich für etwas eignet" verstanden werden. Ein Mittel, das ausgestaltet ist, um eine bestimmte Funktion auszuführen, impliziert deshalb noch nicht, dass solch ein Mittel notwendigerweise auch die Funktion (zu einem gegebenen Zeitpunkt) ausführt.

Funktionen von verschiedenen Elementen, die in den Figuren gezeigt sind, einschließlich irgendwelcher funktioneller Blöcke, die als "Mittel", "Mittel zum Bereitstellen eines Sensorsignals", "Mittel zum Erzeugen eines Übertragungssignals" usw. gekennzeichnet sind, können durch die Verwendung zweckgebundener Hardware zur Verfügung gestellt werden, wie beispielsweise ein "Signallieferant", "eine Signalverarbeitungseinheit", "ein Prozessor", "ein Steuergerät" usw., als auch durch Hardware, die in der Lage ist, Software in Verbindung mit geeigneter Software auszuführen. Darüber hinaus kann jede beliebige Entität, die hier als "Mittel" beschrieben wird, als "ein oder mehrere Module", "eine oder mehrere Vorrichtungen", "eine oder mehrere Einheiten" usw. implementiert sein. Wenn die Funktionen durch einen Prozessor zur Verfügung gestellt werden, können sie durch einen einzelnen zweckgebundenen Prozessor, einen einzelnen gemeinsam genutzten Prozessor oder durch eine Vielzahl von individuellen Prozessoren, von denen einige gemeinsam genutzt werden können, zur Verfügung gestellt werden. Darüber hinaus sollte die ausdrückliche Verwendung des Begriffs "Prozessor" oder "Steuergerät" nicht so ausgelegt werden, dass sie sich ausschließlich auf Hardware bezieht, die in der Lage ist, Software auszuführen, und kann implizit ohne Einschränkung digitale Signalprozessor-Hardware (DSP, Digital Signal Processor), einen Netzwerkprozessor, eine anwendungsspezifisch Intergrierte Schaltung (ASIC, Application Specific Integrated Circuit), eine im Anwendungsfeld programmierbare (Logik-)Gatter-Anordnung (FPGA, Field Programmable Gate Array), Nur-Lese-Speicher (ROM, Read Only Memory) zum Speichern von Software, Direktzugriffsspeicher (RAM, Random Access Memory) und nicht-flüchtige Speicher mit einschließen. Andere Hardware, herkömmlich und/oder kundenspezifisch, kann auch mit eingeschlossen sein.

Es sollte von den Fachleuten auf diesem Gebiet anerkannt werden, dass alle beliebigen Blockdiagramme hier konzeptuelle Ansichten von veranschaulichender Schaltungsanordnung repräsentieren, welche die Prinzipien der Offenbarung verkörpern. Gleichfalls wird anerkannt, dass beliebige Ablaufschaubilder, Ablaufdiagramme, Zustandsübergangsdiagramme, symbolischer Code und dergleichen verschiedene Prozesse repräsentieren, welche im Wesentlichen in computerlesbaren Medien repräsentiert werden können und so durch einen Computer oder Prozessor, ob nun solch ein Computer oder Prozessor ausdrücklich gezeigt wird oder nicht, ausgeführt werden.

Der Schutzbereich der vorliegenden Erfindung wird ausschließlich von dem Umfang der Ansprüche abgedeckt.

## Patentansprüche

1. Ein Überbrückungselement (10) zur Überbrückung einer Batteriezelle oder Akkumulatorzelle, mit folgenden Merkmalen:
einem Halbleitersubstrat mit einem an einer Oberfläche des Halbleitersubstrats angeordneten ersten Dotierungsgebiet (3) und einem an das erste Dotierungsgebiet angrenzendes zweites Dotierungsgebiet (4), wobei das erste Dotierungsgebiet (3) einen ersten Leitfähigkeitstyp und das zweite Dotierungsgebiet (4) einen zweiten Leitfähigkeitstyp aufweist, wobei der pn-Übergang zwischen dem ersten Dotierungsgebiet (3) und dem zweiten Dotierungsgebiet (4) zumindest teilweise weniger als 5µm von einem an der Oberfläche des Halbleitersubstrats angeordneten Anschlussbereich des ersten Dotierungsgebiets (3) entfernt angeordnet ist;
einer ersten Anschlussstruktur (2), die in dem Anschlussbereich des ersten Dotierungsgebiets (3) mit dem ersten Dotierungsgebiet (3) in Kontakt ist und zumindest teilweise ein zur Diffusion in das Halbleitersubstrat vorgesehenes, elektrisch leitfähiges Material aufweist, wobei die erste Anschlussstruktur (2) ausgelegt ist, sodass das zur Diffusion in das Halbleitersubstrat vorgesehene, elektrisch leitfähige Material bei Auftreten von vordefinierten Auslösekonditionen zumindest teilweise durch das erste Dotierungsgebiet (3) bis in das zweite Dotierungsgebiet (4) diffundiert; und
einer zweiten Anschlussstruktur (5), die in einem Anschlussbereich des zweiten Dotierungsgebiets (4) mit dem zweiten Dotierungsgebiet (4) in Kontakt ist,
wobei das zur Diffusion in das Halbleitersubstrat vorgesehene, elektrisch leitfähige Material der ersten Anschlussstruktur (2) ein in dem Halbleitersubstrat den zweiten Leitfähigkeitstyp ergebender Dotierstoff ist.

2. Das Überbrückungselement nach Anspruch 1, wobei das zur Diffusion in das Halbleitersubstrat vorgesehene, elektrisch leitfähige Material Aluminium mit einem Reinheitsgrad von mehr als 95% ist.

3. Das Überbrückungselement nach einem der vorhergehenden Ansprüche, wobei der pn-Übergang zwischen 100nm und 250nm von dem an der Oberfläche des Halbleitersubstrats angeordneten Anschlussbereich des ersten Dotierungsgebiets (3) entfernt angeordnet ist.

4. Das Überbrückungselement nach einem der vorhergehenden Ansprüche, wobei eine durchschnittliche Dotierstoffkonzentration in dem ersten Dotierungsgebiet (3) höher als 4^{∗}10¹⁸cm⁻³ ist.

5. Das Überbrückungselement nach einem der vorhergehenden Ansprüche, wobei eine durchschnittliche Dotierstoffkonzentration in dem zweiten Dotierungsgebiet (4) höher als 1^{∗}10¹⁸cm⁻³ ist.

6. Das Überbrückungselement nach einem der vorhergehenden Ansprüche, wobei der Anschlussbereich der zweiten Anschlussstruktur (8) an einer Rückseite des Halbleitersubstrats angeordnet ist, die der den Anschlussbereich der ersten Anschlussstruktur (2) aufweisenden Oberfläche des Halbleitersubstrats gegenüber liegt.

7. Verfahren (1200) zur Überbrückung einer Batteriezelle oder Akkumulatorzelle, mit folgenden Schritten:
Sperren (1210) eines Stromflusses durch ein Überbrückungselement, das ein Halbleitersubstrat mit einem an einer Oberfläche des Halbleitersubstrats angeordneten ersten Dotierungsgebiet und einem an das erste Dotierungsgebiet angrenzendes zweites Dotierungsgebiet aufweist, wobei das erste Dotierungsgebiet einen ersten Leitfähigkeitstyp und das zweite Dotierungsgebiet einen zweiten Leitfähigkeitstyp aufweist, wobei der pn-Übergang zwischen dem ersten Dotierungsgebiet und dem zweiten Dotierungsgebiet zumindest teilweise weniger als 5µm von einem an der Oberfläche des Halbleitersubstrats angeordneten Anschlussbereich des ersten Dotierungsgebiets entfernt angeordnet ist,
wobei das Überbrückungselement eine zumindest teilweise zur Diffusion in das Halbleitersubstrat vorgesehenes, elektrisch leitfähiges Material aufweisenden ersten Anschlussstruktur aufweist, die in dem Anschlussbereich des ersten Dotierungsgebiets mit dem ersten Dotierungsgebiet in Kontakt ist; und
Überführen (1220) des Überbrückungselements in einen leitenden Zustand bei Auftreten von vordefinierten Auslösekonditionen durch zumindest teilweises Diffundieren des zur Diffusion in das Halbleitersubstrat vorgesehenen, elektrisch leitfähigen Materials durch das erste Dotierungsgebiet bis in das zweite Dotierungsgebiet.

## Claims

1. A bridging element (10) for bridging a battery cell or accumulator cell, comprising the following features:
a semiconductor substrate with a first doping region (3) arranged at a surface of the semiconductor substrate and a second doping region (4) adjacent to the first doping region, wherein the first doping region (3) comprises a first conductivity type and the second doping region (4) comprises a second conductivity type, wherein the p-n-junction between the first doping region (3) and the second doping region (4) is at least partially arranged less than 5 µm away from a contact area of the first doping region (3) arranged at the surface of the semiconductor substrate;
a first contact structure (2) which is in contact with the first doping region (3) in the contact area of the first doping region (3) and comprises at least partially an electrically conductive material provided for a diffusion into the semiconductor substrate, wherein the first contact structure (2) is configured so that the electrically conductive material provided for a diffusion into the semiconductor substrate diffuses at least partially through the first doping region (3) into the second doping region (4) in case predefined trigger conditions occur; and
a second contact structure (5) which is in contact with the second doping region (4) in a contact area of the second doping region (4),
wherein the electrically conductive material of the first contact structure (2) provided for a diffusion into the semiconductor substrate is a dopant yielding the second conductivity type in the semiconductor substrate.

2. The bridging element of claim 1, wherein the electrically conductive material provided for a diffusion into the semiconductor substrate is aluminum having a degree of purity of more than 95%.

3. The bridging element of any of the preceding claims, wherein the p-n-junction is arranged between 100 nm and 250 nm away from the contact area of the first doping region (3) arranged on the surface of the semiconductor substrate.

4. The bridging element of any of the preceding claims, wherein an average dopant concentration in the first doping region (3) is higher than 4^{∗}10¹⁸cm⁻³.

5. The bridging element of any of the preceding claims, wherein an average dopant concentration in the second doping region (4) is higher than 1^{∗}10¹⁸cm⁻³

6. The bridging element according to any of the preceding claims, wherein the contact area of the second contact structure (8) is arranged on a backside of the semiconductor substrate opposite to the surface of the semiconductor substrate comprising the contact area of the first contact structure (2).

7. A method (1200) for bridging a battery cell or accumulator cell, comprising the following steps:
blocking (1210) a current flow through a bridging element which comprises a semiconductor substrate with a first doping region arranged at a surface of the semiconductor substrate and a second doping region adjacent to the first doping region, wherein the first doping region comprises a first conductivity type and the second doping region comprises a second conductivity type, wherein the p-n-junction between the first doping region and the second doping region is at least partially arranged less than 5µm away from a contact area of the first doping region arranged at the surface of the semiconductor substrate,
wherein the bridging element comprises a first contact structure comprising electrically conductive material at least partially provided for a diffusion into the semiconductor substrate, which is in contact with the first doping region in the contact area of the first doping region; and
transferring (1220) the bridging element into a conducting state in case predefined trigger conditions occur by at least partially diffusing the electrically conductive material, provided for a diffusion into the semiconductor substrate, through the first doping region into the second doping region.

## Revendications

1. Un élément de pontage (10) pour ponter une pile ou une cellule d'accumulateur, comprenant les caractéristiques suivantes :
un substrat semi-conducteur comportant une première région de dopage (3) disposée sur une surface du substrat semi-conducteur et une deuxième région de dopage (4) adjacente à la première région de dopage, la première région de dopage (3) présentant un premier type de conductivité et la deuxième région de dopage (4) présentant un deuxième type de conductivité, la jonction pn entre la première région de dopage (3) et la deuxième région de dopage (4) étant disposée au moins partiellement à moins de 5 µm d'une zone de raccordement de la première région de dopage (3) disposée sur la surface du substrat semi-conducteur ;
une première structure de raccordement (2) qui est en contact avec la première région de dopage (3) dans la zone de raccordement de la première région de dopage (3) et qui présente au moins partiellement un matériau électroconducteur prévu pour une diffusion dans le substrat semi-conducteur, la première structure de raccordement (2) étant configurée de telle sorte qu'en cas d'apparition de conditions de déclenchement prédéfinies, le matériau électroconducteur prévu pour une diffusion dans le substrat semi-conducteur diffuse au moins partiellement à travers la première région de dopage (3) dans la deuxième région de dopage (4) ; et
une deuxième structure de raccordement (5) qui est en contact avec la deuxième région de dopage (4) dans une zone de raccordement de la deuxième région de dopage (4),
le matériau électroconducteur de la première structure de raccordement (2) prévue pour une diffusion dans le substrat semi-conducteur étant un dopant donnant le deuxième type de conductivité dans le substrat semi-conducteur.

2. L'élément de pontage selon la revendication 1, le matériau électroconducteur prévu pour une diffusion dans le substrat semi-conducteur est de l'aluminium avec un degré de pureté supérieur à 95%.

3. L'élément de pontage selon l'une des revendications précédentes, la jonction pn étant disposée entre 100 nm et 250 nm de la zone de raccordement de la première région de dopage (3) disposée sur la surface du substrat semi-conducteur.

4. L'élément de pontage selon l'une des revendications précédentes, une concentration moyenne de dopant dans la première région de dopage (3) étant supérieure à 4^{∗}10¹⁸cm⁻³.

5. L'élément de pontage selon l'une des revendications précédentes, une concentration moyenne de dopant dans la deuxième région de dopage (4) étant supérieure à 1^{∗}10¹⁸cm⁻³

6. L'élément de pontage selon l'une des revendications précédentes, la zone de raccordement de la deuxième structure de raccordement (8) étant disposée sur un dos du substrat semi-conducteur opposé à la surface du substrat semi-conducteur présentant la zone de raccordement de la première structure de raccordement (2).

7. Un procédé (1200) pour ponter une pile ou une cellule d'accumulateur, comprenant les étapes suivantes :
couper (1210) un flux de courant par un élément de pontage présentant un substrat semi-conducteur comportant une première région de dopage disposée sur une surface du substrat semi-conducteur et une deuxième région de dopage adjacente à la première région de dopage, la première région de dopage présentant un premier type de conductivité et la deuxième région de dopage présentant un deuxième type de conductivité, la jonction pn entre la première région de dopage et la deuxième région de dopage étant disposée au moins partiellement à moins de 5 µm d'une zone de raccordement de la première région de dopage disposée sur la surface du substrat semi-conducteur,
l'élément de pontage présentant une première structure de raccordement, prévue au moins partiellement pour une diffusion dans le substrat semi-conducteur et présentant un matériau électroconducteur, qui est en contact avec la première région de dopage dans la zone de raccordement de la première région de dopage ; et
transférer (1220) l'élément de pontage à un état conducteur, en cas d'apparition de conditions de déclenchement prédéfinies, par une diffusion au moins partielle du matériau électroconducteur prévu pour une diffusion dans le substrat semi-conducteur à travers la première région de dopage dans la deuxième région de dopage.
